(19) Europäisches Patentamt / European Patent Office / Office européen des brevets

(11) **EP 2 382 510 B1**

(12) **EUROPÄISCHE PATENTSCHRIFT**

(45) Veröffentlichungstag und Bekanntmachung des Hinweises auf die Patenterteilung:
**15.03.2017   Patentblatt 2017/11**

(21) Anmeldenummer: **10701208.0**

(22) Anmeldetag: **25.01.2010**

(51) Int Cl.:
**G03F 7/20** *(2006.01)*

(86) Internationale Anmeldenummer:
**PCT/EP2010/000411**

(87) Internationale Veröffentlichungsnummer:
**WO 2010/086127 (05.08.2010 Gazette 2010/31)**

(54) **BELEUCHTUNGSSYSTEM FÜR DIE MIKRO-LITHOGRAPHIE**

ILLUMINATION SYSTEM FOR MICROLITHOGRAPHY

SYSTÈME D'ÉCLAIRAGE POUR LA MICROLITHOGRAPHIE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **29.01.2009   DE 102009006685**

(43) Veröffentlichungstag der Anmeldung:
**02.11.2011   Patentblatt 2011/44**

(73) Patentinhaber: **Carl Zeiss SMT GmbH**
**73447 Oberkochen (DE)**

(72) Erfinder:
• **SCHOLZ, Axel**
  **73430 Aalen (DE)**
• **SCHLESENER, Frank**
  **73447 Oberkochen (DE)**
• **HAVERKAMP, Nils**
  **73431 Aalen (DE)**
• **DAVYDENKO, Vladimir**
  **76332 Bad Herrenalb (DE)**
• **GERHARD, Michael**
  **73432 Aalen (DE)**
• **ZIEGLER, Gerhard-Wilhelm**
  **73432 Aalen (DE)**
• **KERN, Mirco**
  **73560 Böbingen a.d. R (DE)**
• **BISCHOFF, Thomas**
  **89551 Köngisbronn (DE)**
• **STAMMLER, Thomas**
  **73430 Aalen (DE)**
• **KELLNER, Stephan**
  **73434 Aalen (DE)**
• **MAUL, Manfred**
  **73434 Aalen (DE)**
• **WALLDORF, Daniel**
  **60486 Frankfurt (DE)**
• **HUREVICH, Igor**
  **66125 Saarbrücken (DE)**
• **DEGÜNTHER, Markus**
  **73432 Aalen (DE)**

(74) Vertreter: **Hofmann, Stefan**
**Rau, Schneck & Hübner**
**Patentanwälte Rechtsanwälte PartGmbB**
**Königstraße 2**
**90402 Nürnberg (DE)**

(56) Entgegenhaltungen:
EP-A1- 1 521 111       EP-A2- 0 844 530
DE-A1- 10 344 010      US-A- 5 237 367
US-A- 5 251 067        US-A- 5 963 305

EP 2 382 510 B1

**Beschreibung**

Die Erfindung betrifft ein Beleuchtungssystem für die Mikro-Lithographie zur Beleuchtung eines Beleuchtungsfeldes mit Beleuchtungslicht. Ferner betrifft die Erfindung eine Mikro-Lithographie-Projektionsbelichtungsanlage mit einem derartigen Beleuchtungssystem, ein mikrolithographisches Herstellungsverfahren für mikro- bzw. nanostrukturierte Bauelemente und ein mit einem solchen Verfahren hergestelltes Bauelement.

Ein Beleuchtungssystem der eingangs genannten Art ist bekannt aus der WO 2007/093 433 A1. Die EP 1 521 111 A1 beschreibt eine Beleuchtungsvorrichtung. Die US 5 237 367 beschreibt ein optisches Beleuchtungssystem und eine dieses einsetzende Belichtungsanlage. Die EP 0 844 530 A2 beschreibt ein Verfahren zur Rauschunterdrückung bei Beleuchtungseinrichtungen für scannende Lithographiesysteme. Die US 5 251 067 beschreibt ein Linsenarray (flyeye lens device) und ein dieses einsetzendes Beleuchtungssystem. Die US 5 963 305 beschreibt ein Beleuchtungssystem und eine Belichtungsanlage. Die DE 103 44 010 A1 beschreibt einen Wabenkondensor und ein diesen einsetzendes Beleuchtungssystem.

Es ist eine Aufgabe der vorliegenden Erfindung, ein Beleuchtungssystem der eingangs genannten Art derart weiterzubilden, dass eine Beeinflussung bestimmter Beleuchtungsparameter der Beleuchtung des Beleuchtungs- oder Objektfeldes möglichst ohne unerwünschte Beeinflussung anderer Beleuchtungsparameter möglich ist.

Diese Aufgabe ist gemäß einem ersten Aspekt erfindungsgemäß gelöst durch ein Beleuchtungssystem mit den im Anspruch 1 angegebenen Merkmalen.

Erfindungsgemäß wurde erkannt, dass eine Abstands-Typ-Zuordnung zwischen Rasterelementen der Rasteranordnungen des Beleuchtungssystems zur Möglichkeit führt, einen unterschiedlich sammelnden Effekt der unterschiedlichen Typen der ersten Rasterelemente der ersten Rasteranordnung auf die zugeordneten Teilbündel teilweise oder ganz zu kompensieren. Es können dann andere, die Teilbündel des Beleuchtungslichts beeinflussende Wirkungsunterschiede zwischen den einzelnen Rasterelement-Typen, insbesondere Wirkungen höherer Ordnung, genutzt werden, ohne dass die Unterschiede im sammelnden Effekt der unterschiedlichen Typen der ersten Rasterelemente, die sich in vielen Fällen als unvermeidlich herausgestellt haben, eine unerwünschte Rolle spielen. Soweit brechende Rasterelemente eingesetzt werden, ist es beispielsweise möglich, einen unerwünschten Effekt unterschiedlicher Linsenradien der Rasterelemente zu kompensieren, so dass bei der Verwendung asphärischer Linsenformen andere Formbeiträge, beispielsweise Formbeiträge höherer Ordnung, zu Kompensationszwecken bestimmter Beleuchtungsparameter genutzt werden können. Mit dem erfindungsgemäßen Beleuchtungssystem ist entweder eine Korrektur bestimmter Beleuchtungsparameter oder auch eine Vorkompensation bestimmter Beleuchtungsparameter möglich. Beispielsweise kann durch den Einsatz unterschiedlicher Typen von Rasterelementen mindestens einer der Rasteranordnungen eine Elliptizitätskorrektur erfolgen, ohne dass hierdurch ein unerwünschter Einfluss auf eine Intensitätsverteilung aus den unterschiedlichen Beleuchtungsrichtungen über das Beleuchtungsfeld folgt. Auch reflektierende Rasterelemente können zum Einsatz kommen. Der Unterschied zwischen verschiedenen Typen der Rasterelemente ergibt sich dann nicht aufgrund eines Unterschieds in der brechenden, sondern aufgrund eines Unterschieds in der reflektierenden Wirkung der Rasterelemente. Auch gekippte Linsen können als Rasterelemente zum Einsatz kommen. Die Ausführung der Rasterelemente kann einstückig oder monolithisch sein, so dass eine Rasteranordnung aus einem monolithischen Linsen- oder Substratblock gefertigt ist. Alternativ ist es möglich, die Rasteranordnungen mehrteilig auszugestalten, wobei zu einem dieser Teile eine Gruppe von Rasterelementen oder auch ein einzelnes Rasterelement gehören kann. Eine Variation des individuellen Abstandes zwischen dem Rasterelement eines bestimmten Typs einer der Rasteranordnungen und dem zugeordneten Rasterelement der anderen Rasteranordnung kann die Form einer streng monotonen Funktion haben, die die Variation des Abstandes über den der Bündelführung dienenden Querschnitt der Rasteranordnungen beschreibt. Diese Funktion kann alternativ auch innerhalb des bündelführenden Querschnitts ein Maximum oder ein Minimum haben. Die Abstandsvariation über den Querschnitt kann also insbesondere die Form einer beliebigen Kurvenfunktion mit mindestens einem Scheitelpunkt haben. Grundsätzlich kann jede der beiden Rasteranordnungen auch nur einen Typ von Rasterelementen haben, wobei eine Abstandsvariation über den zur Bündelformung dienenden Querschnitt der Rasteranordnungen entsprechend den vorstehend oder nachstehend erläuterten Funktions- oder Stufenverläufen vorliegen kann. Das Beleuchtungssystem kann eine primäre Lichtquelle aufweisen; dies ist jedoch nicht zwingend. Es ist genauso möglich, das Beleuchtungssystem zum späteren Einsatz gemeinsam mit einer hiervon separaten primären Lichtquelle vorzubereiten. Der freie Abstand zwischen den Rasterelementen der beiden Rasteranordnungen ist durch einen Luftspalt, also durch einen festkörperfreien Zwischenraum, gebildet. Die beiden Rasteranordnungen können als zueinander separate Komponenten ausgeführt sein. Bei der Rasteranordnung, die mindestens zwei Typen von Rasterelementen aufweist, die sich in ihrer bündelbeeinflussenden Wirkung unterscheiden, kann es sich um die erste Rasteranordnung, um die zweite Rasteranordnung oder um beide Rasteranordnungen handeln.

Mindestens eine Abstandsstufe nach Anspruch 2 stellt eine diskrete Realisierung der erfindungsgemäßen Abstandszuordnung dar. Eine derartige Abstandsstufe lässt sich beispielsweise schon in einem Rohkörper der Rasteranordnung vorgeben.

Eine Typzuordnung der Rasterelemente zu den Rasterbereichen nach Anspruch 3 ermöglicht eine reproduzierbare Fertigung und zudem eine reproduzierbare Auslegung des Beleuchtungssystems. Die Rasterbereiche können jeweils ausschließlich Rasterelemente des gleichen Typs aufweisen.

Ausgestaltungen der die mindestens eine Abstandsstufe aufweisenden Rasteranordnung nach den Ansprüchen 4 und 5 ermöglichen je nach der Typzuordnung der Rasterelemente zum Zentrum und zum Rand entsprechende kompensatorische Wirkungen.

Bei einer Ausführung der Rasterelemente nach Anspruch 6 oder 7 kommen die Vorteile der Abstandszuordnung besonders gut zum Tragen. Eine erwünschte Beeinflussung bestimmter Beleuchtungsparameter kann über verschiedene konische Konstanten der verschiedenen Typen der ersten Rasterelemente bewirkt werden. Die unterschiedlichen Typen der Rasterelemente können alternativ oder zusätzlich einen unterschiedlichen Krümmungsradius der bündelbeeinflussenden Flächen der Rasterelemente haben, was durch die Abstands-Typ-Zuordnung in erwünschtem Maße kompensiert werden kann. Es ist also auch eine sphärische Ausgestaltung der Rasterelemente möglich, wobei sich die unterschiedlichen Typen im Krümmungsradius unterscheiden. Über die unterschiedlichen konischen Konstanten lässt sich z. B. eine kontrollierte Intensitätsvariation über das Beleuchtungsfeld zu Korrektur-, Kompensations- oder Vorkompensationszwecken einführen. Alternativ oder zusätzlich kann eine erwünschte Beeinflussung bestimmter Beleuchtungsparameter über unterschiedliche Radien oder auch allgemeiner über eine unterschiedliche Gestaltung von nicht rotationssymmetrisch ausgeführten Freiform-Oberflächen der verschiedenen Typen der ersten Rasterelemente bewirkt werden.

Die eingangs genannte Aufgabe ist gemäß einem zweiten Aspekt zudem erfindungsgemäß gelöst durch ein Beleuchtungssystem mit den im Anspruch 8 angegebenen Merkmalen.

Die erfindungsgemäße Verlagerungseinrichtung kann zur Verlagerung des mindestens einen Abschnitts der ersten Rasteranordnung relativ zur zweiten Rasteranordnung im Wesentlichen längs einer Strahlrichtung des Beleuchtungslichts und/oder im Wesentlichen quer zu einer Strahlrichtung des Beleuchtungslichts und/oder zum Verschwenken einer der Rasteranordnungen relativ zur anderen Rasteranordnung ausgeführt sein. Bei der Verlagerung der beiden Rasteranordnungen relativ zueinander kann die erste Rasteranordnung verlagert werden, kann die zweite Rasteranordnung verlagert werden oder es können auch beide Rasteranordnungen verlagert werden. Der mittels der Verlagerungseinrichtung verlagerbare Abschnitt kann genau eines der Rasterelemente, kann eine Gruppe von mehreren Rasterelementen, insbesondere eine Rasterzeile, eine Rasterspalte oder einen definierten Rasterbereich, kann mehrere Gruppen von Rasterelementen oder kann alle Rasterelemente, also die gesamte Rasteranordnung, beinhalten. Das Beleuchtungssystem gemäß dem ersten Aspekt mit der Verlagerungseinrichtung kann mit dem Beleuchtungssystem gemäß dem zweiten Aspekt mit den mindestens zwei Typen von Rasterelementen, die sich in ihrer bündelbeeinflussenden Wirkung unterscheiden, kombiniert werden. Sämtliche Merkmale der vorstehend beschriebenen Erfindung sind daher miteinander kombinierbar.

Eine Verlagerungseinrichtung nach Anspruch 11 kann zur Ausnutzung eines Mittelungseffektes über den oder die vorzugebenden Beleuchtungsparameter genutzt werden.

Eine Ausgestaltung des Beleuchtungssystems nach Anspruch 12 ermöglicht eine Rückkopplung, also eine Ansteuerung der Verlagerungseinrichtung abhängig vom Messergebnis der Messeinrichtung. Eine derartige Rückkopplung wird auch als Online Feedback-Loop bezeichnet. Die Messeinrichtung kann die Beleuchtungsintensitätsverteilung in der Feldebene des Beleuchtungsfeldes oder in einer hierzu konjugierten Ebene und/oder in einer Pupillenebene des Beleuchtungssystems oder in einer hierzu konjugierten Ebene erfassen. Auch eine Erfassung in einer zwischen einer Feld- und einer Pupillenebene gelegenen Ebene des Beleuchtungssystems ist möglich. Eine Pupillenebene ist dabei eine Ebene, in der eine Intensitätsverteilung des Beleuchtungslichts ein Maß für eine Beleuchtungswinkelverteilung der Beleuchtung des Beleuchtungsfeldes darstellt.

Die Vorteile einer Projektionsbelichtungsanlage nach Anspruch 13, eines Herstellungsverfahrens nach Anspruch 14 und eines mit diesem Verfahren hergestellten mikro- bzw. nanostrukturierten Bauelements entsprechen denen, die vorstehend unter Bezugnahme auf das erfindungsgemäße Beleuchtungssystem bereits erläutert wurden.

Ausführungsbeispiele der Erfindung werden nachfolgend anhand der Zeichnung näher erläutert. In dieser zeigen:

Fig. 1    schematisch einen Meridionalschnitt durch ein erfindungsgemäßes Beleuchtungssystem innerhalb einer MikroLithographie-Projektionsbelichtungsanlage mit einem Rastermodul mit einer zweistufigen schematisch und nicht erfindungsgemäß dargestellten Rasteranordnung;

Fig. 2    eine erfindungsgemäße Ausführung des Rastermoduls des Beleuchtungssystems nach Fig. 1 mit einer nicht abgestuften ersten Rasteranordnung und einer elementweise abgestuften zweiten Rasteranordnung;

Fig. 3    eine Aufsicht auf die erste Rasteranordnung nach Fig. 2, wobei schematisch fünf Rasterbereiche dargestellt sind, in denen jeweils einer von insgesamt drei unterschiedlichen Rasterelement-Typen vorliegt;

Fig. 4      schematisch in einem Diagramm nicht abstandskompensierte Intensitätsverteilungen I(x) über ein vom Beleuchtungssystem ausgeleuchtetes Beleuchtungsfeld für zwei der insgesamt drei Rasterelement-Typen der ersten Rasteranordnung des Rastermoduls nach Fig. 3;

Fig. 5 bis 10      weitere Ausführungen von Rastermodulen mit elementbzw. bereichsweise abgestuften Rasteranordnungen;

Fig. 11      einen Meridionalschnitt durch ein Rastermodul mit zwei reflektierenden Rasteranordnungen mit typweise individuellen Abständen zwischen den einander zugeordneten Rasterelementen der beiden Rasteranordnungen;

Fig. 12      schematisch ein Rastermodul mit zwei Rasteranordnungen zur Verdeutlichung eines Freiheitsgrades einer Verlagerung der beiden Rasteranordnungen zueinander;

Fig. 13      in einer zu Fig. 12 ähnlichen Darstellung ein Rastermodul mit zwei Rasteranordnungen zur Verdeutlichung zweier weiterer Freiheitsgrade einer Verlagerung der beiden Rasteranordnungen zueinander;

Fig. 14      in einer zu Fig. 12 ähnlichen Darstellung ein Rastermodul mit zwei Rasteranordnungen, wobei Rasterelemente einer der beiden Rasteranordnungen gegenüber der anderen Rasteranordnung individuell verlagerbar sind;

Fig. 15      in einer zu Fig. 12 ähnlichen Darstellung ein Rastermodul mit zwei Rasteranordnungen, wobei wiederum Rasterelemente einer der Rasteranordnungen gegenüber der anderen Rasteranordnung individuell verlagerbar sind;

Fig. 16      in einer zu Fig. 3 ähnlichen Darstellung eine Ausführung einer Rasteranordnung mit drei Rasterbereichen, die jeweils eine Mehrzahl von Rasterspalten von Rasterelementen umfassen, wobei die Rasterbereiche gegeneinander verlagerbar sind;

Fig. 17      in einer zu Fig. 4 ähnlichen Darstellung die Auswirkung einer Verlagerung der Rasterbereiche der Rasteranordnung nach Fig. 16 auf die Intensitätsverteilung über das Beleuchtungsfeld;

Fig. 18      die sich aus der Änderung der Intensitätsverteilung nach Fig. 17 ergebende Änderung eines Verlaufs einer Telezentrie über das Beleuchtungsfeld;

Fig. 19      in einer zu Fig. 16 ähnlichen Darstellung eine weitere Ausführung einer Rasteranordnung mit drei Rasterbereichen, die gegeneinander verlagerbar ausgeführt sind;

Fig. 20      in einer zu Fig. 17 ähnlichen Darstellung die Auswirkungen einer Verlagerung der Rasterbereiche der Rasteranordnung nach Fig. 19 zueinander auf die Intensitätsverteilung über das Beleuchtungsfeld und

Fig. 21      die sich hieraus ergebenden Auswirkungen auf einen Elliptizitätsverlauf über das Beleuchtungsfeld.

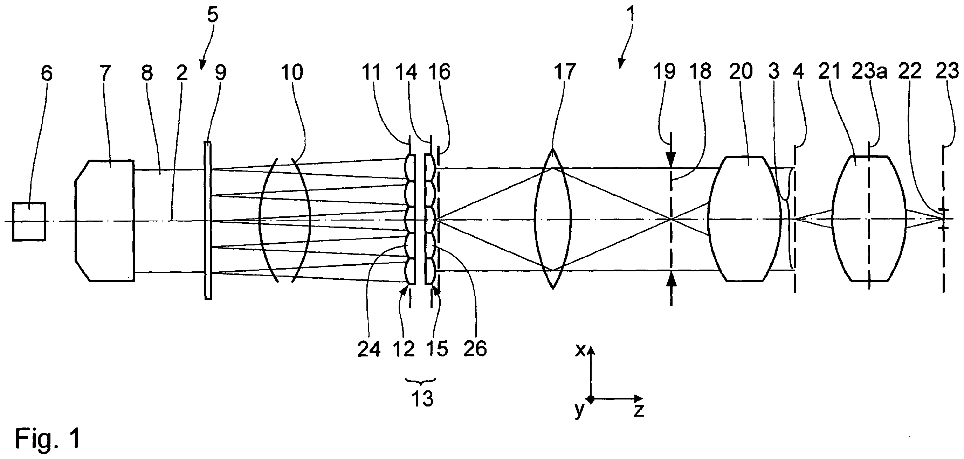

Fig. 1 zeigt schematisch eine Mikro-Lithographie-Projektionsbelichtungsanlage 1, die als Wafer-Scanner ausgeführt ist und bei der Herstellung von Halbleiterbauelementen und anderen fein strukturierten Bauteilen eingesetzt wird. Die Projektionsbelichtungsanlage 1 arbeitet zur Erzielung von Auflösungen bis zu Bruchteilen von Mikrometern mit Licht insbesondere aus dem tiefen Ultraviolettbereich (VUV).

Zur Erleichterung von Lagebeziehungen wird nachfolgend ein kartesisches x-y-z-Koordinatensystem verwendet. Die x-Achse verläuft in der Fig. 1 nach oben. Die y-Achse verläuft senkrecht zur Zeichenebene der Fig. 1 auf den Betrachter zu. Die z-Richtung verläuft in der Fig. 1 nach rechts. Eine Scanrichtung der Projektionsbelichtungsanlage 1 verläuft längs der y-Richtung. Im in der Fig. 1 dargestellten Meridionalschnitt sind alle optischen Komponenten der Projektionsbelichtungsanlage 1 längs einer optischen Achse 2 aufgereiht. Es versteht sich, dass auch beliebige Faltungen der optischen Achse 2 möglich sind, insbesondere um die Projektionsbelichtungsanlage 1 kompakt zu gestalten.

Zur definierten Ausleuchtung eines Objekt- bzw. Beleuchtungsfelds 3 in einer Retikelebene 4, in der eine bei der Projektionsbelichtung zu übertragende Struktur in Form eines nicht näher dargestellten Retikels angeordnet ist, dient ein insgesamt mit 5 bezeichnetes Beleuchtungssystem der Projektionsbelichtungsanlage 1. Das Objektfeld 3 und das Beleuchtungsfeld können zusammenfallen. In der Regel liegt das Objektfeld 3 innerhalb des Beleuchtungsfeldes. Als primäre Lichtquelle 6 dient ein $F_2$-Laser mit einer Arbeitswellenlänge von 157 nm, dessen Beleuchtungslichtstrahl koaxial zur optischen Achse 2 ausgerichtet ist. Andere DUV- oder UV-Lichtquellen, beispielsweise ein ArF-Excimer-Laser mit 193 nm Arbeitswellenlänge, ein KrF-Excimer-Laser mit 248 nm Arbeitswellenlänge sowie primäre Lichtquellen mit größeren oder kleineren Arbeitswellenlängen sind ebenfalls möglich.

Zur Vereinfachung der Beschreibung sind Komponenten einer Beleuchtungsoptik des Beleuchtungssystems 5 als brechende optische Komponenten dargestellt. Alternativ oder zusätzlich können diese Komponenten auch durch reflektierende Komponenten, also durch Spiegel, ersetzt oder ergänzt werden. Anstelle des im Wesentlichen dioptrischen Systems nach Fig. 1 kann daher auch ein katadioptrisches System oder ein katoptrisches System zum Einsatz kommen. Eine reflektierende Ausgestaltung des Beleuchtungssystems 5 kann insbesondere dann zum Einsatz kommen, wenn als primäre Lichtquelle 6 eine EUV-Lichtquelle genutzt wird, die Nutzlicht mit einer Wellenlänge im Bereich von 5 nm und 30 nm, insbesondere im Bereich von 13,5 nm erzeugt.

Der von der Lichtquelle 6 kommende Lichtstrahl mit kleinem Rechteckquerschnitt trifft zunächst auf eine Strahlaufweitungsoptik 7, die einen austretenden Strahl 8 mit weitgehendem parallelem Licht und größerem Rechteckquerschnitt erzeugt. Der Beleuchtungslichtstrahl 8 hat ein x/y-Aspektverhältnis, das im Bereich von 1 liegen kann oder auch größer sein kann als 1. Die Strahlaufweitungsoptik 7 kann Elemente aufweisen, die zur Kohärenzreduktion des Beleuchtungslichts 8 dienen. Das durch die Strahlaufweitungsoptik 7 weitgehend parallelisierte Beleuchtungslicht 8 trifft anschließend auf ein diffraktives optisches Element (DOE) 9, das als computergeneriertes Hologramm (CGH) zur Erzeugung einer Beleuchtungslicht-Winkelverteilung ausgebildet ist. Die durch das DOE 9 erzeugte Winkelverteilung des Beleuchtungslichts 8 wird beim Durchtritt durch eine stark schematisch lediglich angedeutete Fourier-Linsenanordnung bzw. einen Kondensor 10, der im Abstand seiner Brennweite vom DOE 9 positioniert ist, in eine zweidimensionale, also senkrecht zur optischen Achse 2 ortsabhängige Beleuchtungslicht-Intensitätsverteilung umgewandelt. Die so erzeugte Intensitätsverteilung ist daher in einer ersten Beleuchtungsebene 11 des Beleuchtungssystems 5 vorhanden. Zusammen mit dem Kondensor 10 stellt das DOE 9 also eine Lichtverteilungseinrichtung zur Erzeugung einer zweidimensionalen Beleuchtungslicht-Intensitätsverteilung dar. Diese Lichtverteilungseinrichtung wird auch als pupillendefinierendes Element (PDE) bezeichnet.

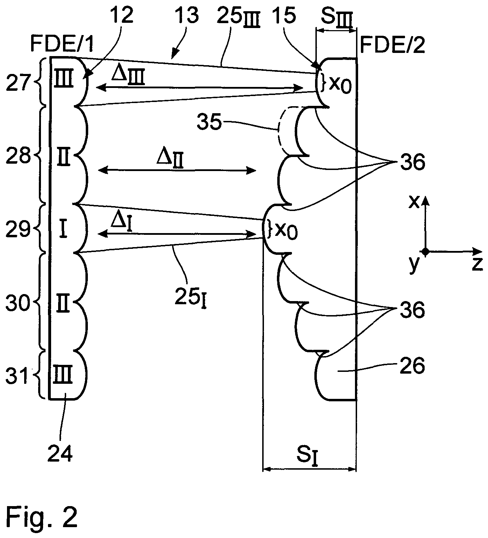

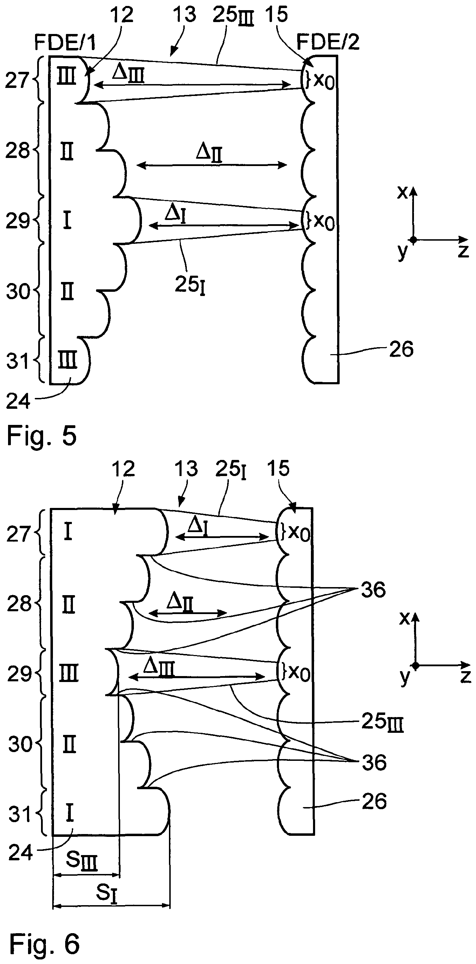

Im Bereich der ersten Beleuchtungsebene 11 ist eine erste Rasteranordnung 12 eines Rastermoduls 13 angeordnet, das auch als Wabenkondensor bezeichnet wird. Das Rastermodul 13 wird auch als felddefinierendes Element (FDE) bezeichnet. Das Rastermodul 13 dient zur Erzeugung einer definierten Intensitäts- und Beleuchtungswinkelverteilung des Beleuchtungslichts 8. In der Fig. 1 ist das Rastermodul 13 lediglich schematisch zur Beschreibung seiner prinzipiellen Funktionsweise dargestellt. Erfindungsgemäße Ausführungen des Rastermoduls 13 zeigen die nachfolgend noch erläuterten Figuren 2 sowie 5 ff.

In einer der ersten Beleuchtungsebene 11 nachgeordneten weiteren Beleuchtungsebene 14 ist eine zweite Rasteranordnung 15 angeordnet. Die beiden Rasteranordnungen 12, 15 bilden den Wabenkondensor 13 des Beleuchtungssystems 5. Der weiteren Beleuchtungsebene 14 nachgeordnet ist eine Pupillenebene 16 des Beleuchtungssystems 5.

Dem Rastermodul 13 nachgeordnet ist ein weiterer Kondensor 17, der auch als Feldlinse bezeichnet wird. Zusammen mit der zweiten Rasteranordnung 15 bildet der Kondensor 17 näherungsweise die erste Beleuchtungsebene 11 in eine Feld-Zwischenebene 18 des Beleuchtungssystems 5 ab. In der Feld-Zwischenebene 18 kann ein Retikel-Masking-System (REMA) 19 angeordnet sein, welches als verstellbare Abschattungsblende zur Erzeugung eines scharfen Randes der Beleuchtungslicht-Intensitätsverteilung dient. Ein nachfolgendes Objektiv 20, das auch als Relay Optik bezeichnet ist, bildet die Feld-Zwischenebene 18 auf das Retikel, das heißt auf die Lithographie-Vorlage, ab. Mit einem Projektionsobjektiv 21 wird das Objektfeld 3 in ein Bildfeld 22 in einer Bildebene 23 auf einen in der Fig. 1 nicht dargestellten Wafer abgebildet, der intermittierend oder kontinuierlich längs der y-Richtung verschoben wird. Bei 23a ist in der Fig. 1 eine Pupillenebene des Projektionsobjektivs 21 angedeutet. Soweit die Projektionsbelichtungsanlage 1 mit einem intermittierenden Vorschub des Retikels und des Wafers arbeitet, wird sie auch als Stepper bezeichnet. Soweit die Projektionsbelichtungsanlage mit einem kontinuierlichen Vorschub des Retikels und des Wafers arbeitet, wird sie auch als Scanner bezeichnet.

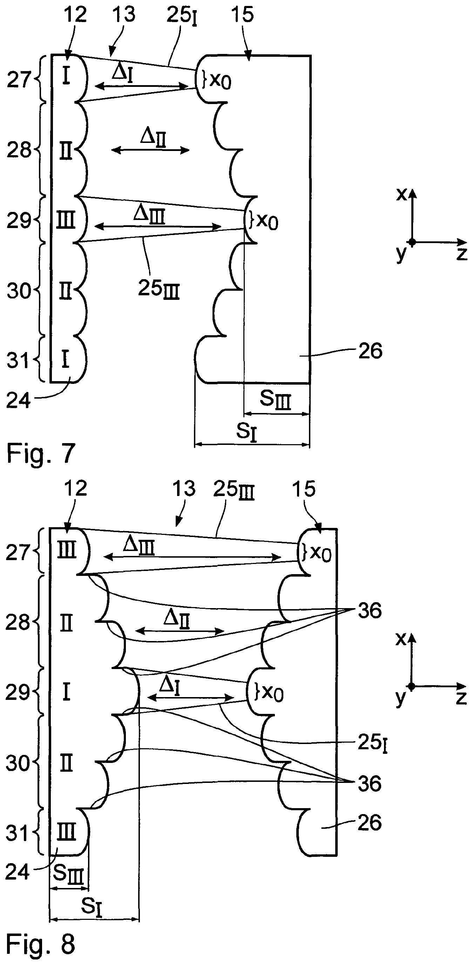

Die erste Rasteranordnung 12 hat einzelne erste Rasterelemente 24, die spalten- und zeilenweise angeordnet sind. Die ersten Rasterelemente 24 haben eine rechteckige Apertur mit einem x/y-Aspektverhältnis von beispielsweise 2 / 1. Auch andere, insbesondere größere Aspektverhältnisse der ersten Rasterelemente 24 sind möglich. Zur Vereinfachung der Darstellung werden nachfolgend in den Fig. 8 bis 10 erste Rasterelemente 24 mit einem x/y-Aspektverhältnis von 1 / 1 dargestellt.

Die Rasteranordnungen 12 und 15 können jeweils auch aus zueinander gekreuzt angeordneten, nebeneinander liegenden Zylinderlinsen bestehen. Jede der Rasteranordnungen 12, 15 kann in diesem Fall als monolithischer Linsenblock ausgeführt sein. Eine der beiden optischen Oberflächen des Linsenblocks weist dann Zylinderlinsenflächen in einer ersten Orientierung auf und die gegenüberliegende der beiden optischen Flächen weist dann Zylinderlinsenflächen in einer hierzu senkrechten Orientierung auf.

Der Meridionalschnitt nach Fig. 1 geht entlang einer x-Rasterspalte. Die ersten Rasterelemente 24 sind als Mikrolinsen mit positiver Brechkraft ausgeführt. Fig. 1 zeigt eine plankonvexe Ausgestaltung dieser Mikrolinsen. Bei der schematischen Darstellung nach Fig. 1 sind die planen Flächen der beiden Rasteranordnungen 12, 15 einander zugewandt. Wie nachfolgend anhand der Fig. 2 und 5 ff. noch erläutert wird, können auch die konvexen Flächen der beiden Rasteranordnungen 12, 15 einander zugewandt sein. Auch eine biokonvexe Ausgestaltung ist möglich. Die Rechtecksform der ersten Rasterelemente 24 entspricht der Rechtecksform des Beleuchtungsfeldes 3. Die ersten Rasterelemente 24 sind in einem ihrer Rechtecksform entsprechenden Raster direkt aneinander angrenzend, das heißt im Wesentlichen flächenfüllend, angeordnet. Die ersten Rasterelemente 24 werden auch als Feldwaben bezeichnet.

Aufgrund der bündelformenden Wirkung der ersten Rasterelemente 24 der ersten Rasteranordnung 12 wird das Beleuchtungslicht 8 in eine der Anzahl der beleuchteten ersten Rasterelemente 24 entsprechende Anzahl von Teilbündeln 25 (vergleiche z. B. Fig. 2) aufgeteilt, die, da sie zunächst separat voneinander im Rastermodul 13 geführt werden, auch als Lichtkanäle oder als Ausleuchtungskanäle bezeichnet werden. Beim Rastermodul 13 können mehrere hundert derartiger in x- und in y-Richtung jeweils um das x- bzw. das y-Rastermaß zueinander versetzt verlaufender Lichtkanäle vorliegen. Diese Lichtkanäle werden im Objektfeld 3 einander überlagert.

Zweite Rasterelemente 26 der zweiten Rasteranordnung 15 sind zur Führung des jeweiligen Teilbündels 25 den ersten Rasterelementen 24 der ersten Rasteranordnung 12 zugeordnet. Auch die zweiten Rasterelemente 26 sind als Mikrolinsen mit positiver Brechkraft ausgeführt.

Dargestellt sind in der Fig. 1 fünf in x-Richtung nebeneinander liegende derartiger Lichtkanäle. Bei den erfindungsgemäßen Ausführungen des Rastermoduls 13 nach den Fig. 2 sowie 5 ff. sind insgesamt sieben in x-Richtung einander benachbarter Rasterelemente 24, 26 zur entsprechenden Erzeugung von sieben benachbarten Teilbündeln bzw. Lichtkanälen 25 dargestellt.

Die zweite Rasteranordnung 15 ist etwa im Abstand der Brennweite der Rasterelemente 24 der ersten Rasteranordnung 12 angeordnet. Die Pupillenebene 16 ist wiederum in etwa im Abstand der Brennweite der zweiten Rasterelemente 26 zur zweiten Rasteranordnung 15 angeordnet.

Die Rasterelemente 24, 26 sind als asphärische Linsen ausgestaltet. Eine Pfeilhöhe h jeder der Linsenflächen der Rasterelemente 24, 26 kann durch folgende Asphärengleichung wiedergegeben werden:

$$h(x) = \frac{x^2}{R\left(1 + \sqrt{1 - (1+C)\left(\frac{x}{R}\right)^2}\right)} + A_4 x^4 + A_6 x^6 + A_8 x^8 + \ldots$$

Hierbei bedeuten:

h(x): Pfeilhöhe in Abhängigkeit von der x-Koordinate (Feld- bzw. Linsenkoordinate);

R: Radius der Mikrolinsenfläche am Scheitelpunkt;

C: Konische Konstante;

$A_n$: Asphärische Entwicklungskonstanten.

Die erste Rasteranordnung 12 hat verschiedene Typen erster Rasterelemente 24, also verschiedene Typen asphärischer Mikrolinsen. Die Typen der ersten Rasterelemente 24 unterscheiden sich in ihrer bündelbeeinflussenden, nämlich in ihrer brechenden Wirkung.

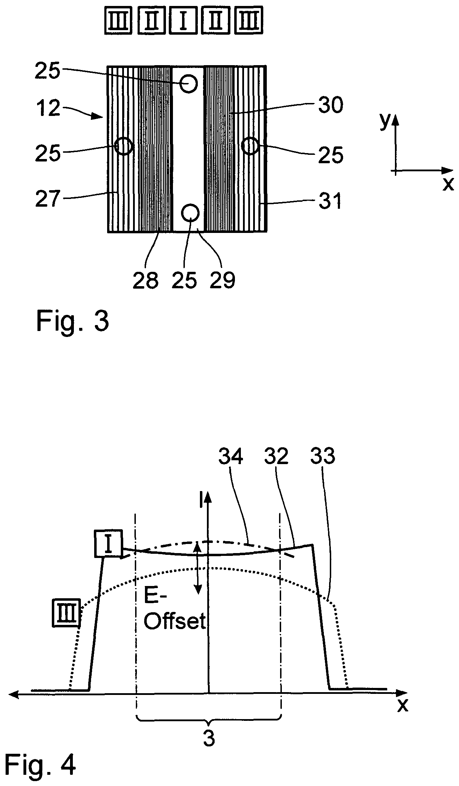

Fig. 3 zeigt eine Unterteilung der ersten Rasteranordnung 12 des Rastermoduls 13 in insgesamt fünf Rasterbereiche 27 bis 31. Jeder der Rasterbereiche 27 bis 31 verläuft dabei spaltenweise in der y-Richtung. Jeder der Rasterbereiche 27 bis 31 kann in der x-Richtung genau ein Rasterelement 24 oder auch eine Mehrzahl von Rasterelementen 24 umfassen. Im Normalfall hat jeder der Rasterbereiche 27 bis 31 eine Mehrzahl von Rasterelementen 24. In jedem der Rasterbereiche 27 bis 31 sind die Rasterelemente 24 genau eines Typs, also mit genau einer brechenden Wirkung, angeordnet.

Die schematische Unterteilung nach Fig. 2 mit insgesamt sieben in der x-Richtung nebeneinander angeordneten Rasterelementen 24 wird zur nachfolgenden Erläuterung wie folgt vorgenommen: Das in der Fig. 2 oberste Rasterelement 24 gehört zum Rasterbereich 27, die beiden nächst benachbarten Rasterelemente 24 gehören zum Rasterbereich 28, das in der Fig. 2 mittlere Rasterelement 24 gehört zum Rasterbereich 29, die beiden wiederum nächst benachbarten Rasterelemente 24 gehören zum Rasterbereich 30 und das in der Fig. 2 unterste Rasterelement 24 gehört zum Rasterbereich 31.

Die Rasterelemente 24 in dem mittleren Rasterbereich 29 gehören zum Typ I der Rasterelemente mit einer konischen Konstante C im Bereich von 0,2 und einem geringsten Linsenradius R, also mit stärkster brechender Wirkung. Die Rasterelemente 24 in den Rasterbereichen 28 und 30 gehören zu einem Typ II mit einer konischen Konstante C im Bereich von 0,05 und einer im Vergleich zu den Rasterelementen 24 im Rasterbereich 29 geringeren brechenden Wirkung, also etwas größerem Linsenradius R. Die Rasterelemente 24 in den Rasterbereichen 27 und 31 gehören zu einem Typ III mit einer konischen Konstante C im Bereich von - 0,1 und einer schwächsten brechenden Wirkung, also einem größten Linsenradius R. Zwischen dem Typ I und dem Typ III liegt also ein Unterschied in der konischen Konstante C von 0,3 vor. Innerhalb eines Wertebereichs der konischen Konstante C zwischen - 0,3 und + 0,3 sind für die konischen Konstanten C der Typen I, II, III auch andere Werte möglich, wobei immer gilt, dass die konische Konstante C für den Typ mit dem stärksten brechender Wirkung am größten und die konische Konstante C für den Typ mit am schwächsten brechender Wirkung am kleinsten ist. Bei einer anderen Variante ist die konische Konstante C für den Typ II im Bereich von 0,05, für den Typ I im Bereich von 0,1 und für den Typ III im Bereich von 0,0. Die konische Konstante C des Typs I kann beispielsweise in einem Bereich zwischen 0,09 und 0,25 variieren. Die konische Konstante des Typs II kann in einem Bereich zwischen - 0,09 und + 0,09 variieren. Die konische Konstante C des Typs III kann in einem Bereich zwischen - 0,25 und - 0,09 variieren.

Fig. 4 verdeutlicht eine nicht abstandskompensierte, also nicht erfindungsgemäße Wirkung der Typen I und III der Rasterelemente 24 aufgrund ihrer unterschiedlichen Brechung. Dargestellt ist eine Intensität I über eine Feldkoordinate x im Bereich des Objektfeldes 3. Aufgrund der starken brechenden Wirkung der Rasterelemente 24 des Typs I ergibt sich eine relativ starke Einschnürung der zugehörigen Teilbündel 25 auf den Eintrittsflächen der zugeordneten zweiten Rasterelemente 26 und entsprechend eine Einschnürung eines Intensitätsverlaufs 32 über die Feldkoordinate x. Die konische Konstante C der Rasterelemente 24 des Typs I führt zu einem "konkaven", also nach oben offen gekrümmten Intensitätsverlauf 32 über das Objektfeld 3.

Die bündelführende Wirkung der Rasterelemente 24 des Typs III führt aufgrund von deren schwächer brechenden Wirkung zu einer geringeren Einschnürung der Teilbündel 25 auf den zweiten Rasterelementen 26 und damit zu einem breiter über die Feldkoordinate x verlaufenden Intensitätsverlauf 33. Aufgrund der konischen Konstante C der Rasterelemente 24 des Typs III ergibt sich über das Objektfeld 3 ein "konvexer", also nach unten offener Intensitätsverlauf 33.

Soweit keine Abstandskompensation, die nachfolgend noch erläutert wird, vorliegt, ergibt sich aufgrund der einschnürenden Wirkung der stärkeren Brechung der Rasterelemente 24 des Typs I im Vergleich zu den Rasterelementen 24 des Typs III ein über das Objektfeld 3 integrierter höherer Intensitätsbeitrag des Typs I verglichen mit dem Typ III, wie unmittelbar aus einem Vergleich der Intensitätshöhen der Intensitätsverläufe 32, 33 über das Objektfeld 3 in der Fig. 4 ersichtlich ist.

Erfindungsgemäß wird dieser Intensitätsunterschied der Verläufe 32, 33 über das Objektfeld 3 durch eine Abstufung von Abständen $\Delta$ zwischen den einander über die Teilbündel 25 zugeordneten Rasterelementen 24, 26 kompensiert. Dies wird nachfolgend anhand der Fig. 2 erläutert. Die Rasterelemente 24 des Typs I haben, wie vorstehend diskutiert, im Vergleich zu den Rasterelementen des Typs III eine stärker brechende Wirkung. Die von den Rasterelementen 24 des Typs I geformten Teilbündel $25_I$ haben daher stärker konvergierende Randstrahlen als die von den Rasterelementen 24 des Typs III erzeugten Teilbündel $25_{III}$. Andererseits ist der Abstand $\Delta_I$ zwischen den Rasterelementen 24, 26 im Rasterbereich 29 geringer als der Abstand $A_{III}$ zwischen den Rasterelementen 24, 26 der Rasterbereiche 27 und 31. Dies bewirkt, dass trotz der stärker brechenden Wirkung der Rasterelemente 24 des Typs I im Vergleich zum Typ III das auf das zugehörige Rasterelement 26 auftreffende Teilbündel 25 unabhängig vom Typ I oder III in der x-Dimension die gleiche Ausdehnung $x_0$ hat. Auch der schwächer brechende Typ III der Rasterelemente 24 erreicht dann über das Objektfeld 3 eine stärker konzentrierte Intensitätswirkung, da aufgrund des größeren Abstandes $\Delta_{III}$ das Teilbündel $25_{III}$ auf die gleiche x-Dimension $x_0$ gesammelt wird wie das Teilbündel $25_I$. Im Bereich des Objektfeldes 3 wird hierdurch der Intensitätsverlauf 33, der vom Typ III herrührt, hin zum strichpunktiert dargestellten Intensitätsverlauf 34 angehoben. Integriert über das Objektfeld 3 liefern damit die beiden unterschiedlich brechenden Typen I und III den gleichen Intensitätsbeitrag, der sich lediglich in seinem konkav bzw. konvex gekrümmten Verlauf aufgrund der unterschiedlichen konischen Konstanten der Typen I und III unterscheidet. Die unterschiedlich brechende Wirkung der Typen I und III führt also zur Möglichkeit einer Offset-Korrektur der Intensität über das genutzte Objektfeld 3, was in der Figur 4 mit "E-Offset" und einen längs der Intensitätsachse verlaufenden Doppelpfeil angedeutet ist.

Die brechende Wirkung des Typs II der Rasterelemente 24 in den Rasterbereichen 28, 30 liegt zwischen den brechenden Wirkungen der Typen I und III, so dass sich für den Typen II ein entsprechender, intensitätsangleichender Effekt ergibt. Bei der schematischen Darstellung des Rastermoduls 13 nach Fig. 2 sind in den Rasterbereichen 28, 30 zwei unterschiedliche Abstände $\Delta$ zwischen den zugeordneten Rasterelementen 24, 26 wiedergegeben, so dass eine elementweise Abstufung der zweiten Rasteranordnung 15 vorliegt. Die zweiten Rasterelemente 26 der zweiten Rasteranordnung 15 können alternativ auch mit einheitlichem Abstand $\Delta$ zu den zugehörigen Rasterelementen 24 der ersten Rasteranordnung 12 vorliegen, wie in der Fig. 2 gestrichelt bei 35 dargestellt. Es liegt dann ein einheitlicher Abstand $\Delta_{II}$ vor.

Der Abstandsverlauf mit den unterschiedlichen Abständen $\Delta_I$, $\Delta_{II}$ und $\Delta_{III}$ wird durch eine über die x-Richtung dachfirstartig verlaufende Stärkenvariation der zweiten Rasteranordnung 15 erreicht. Die zweite Rasteranordnung 15 hat im Zentrum, also im Rasterbereich 29, eine größte Rasterstärke $S_I$ und am Rand, also in den Rasterbereichen 27, 31, eine geringste Stärke $S_{III}$. Die in der z-Richtung gemessene Stärke S nimmt bei der durchgezogenen Darstellung der zweiten Rasteranordnung 15 elementweise über Abstandsstufen 36 ab.

Die Abstände Δ zwischen den Rasteranordnungen 12, 15 sind in den Fig. 2 sowie 5 ff. im Vergleich zur jeweiligen x-Dimension der Rasterelemente 24, 26 stark übertrieben dargestellt.

Die nachfolgenden Tabellen zeigen beispielhaft, welche absolute Abstands- bzw. Luftspaltänderung bei einer Änderung der konischen Konstante C oder bei einer Änderung des Krümmungsradius des jeweiligen ersten Rasterelements 24 erforderlich ist. Die Änderung der konischen Konstante C ist in der ersten Tabelle mit ΔC bezeichnet.

Eine Änderung der konischen Konstante C von 0,05 erfordert beispielsweise zur Kompensation eine Änderung des Abstands Δ von 13 μm.

Die Änderung des Radius ist in der zweiten nachfolgenden Tabelle prozentual angegeben.

| ΔC | Luftspaltänderung [μm] |
|---|---|
| 0,05 | 13 |
| 0,1 | 27 |
| 0,2 | 53 |
| 0,3 | 80 |

| Radienänderung [%] | Luftspaltänderung [μm] |
|---|---|
| 1 | 16 |
| 2 | 29 |
| 3 | 45 |
| 5 | 74 |

Fig. 3 zeigt eine beispielhafte Quadrupol-Beleuchtung der ersten Rasteranordnung 12 und damit des Rastermoduls 13 des Beleuchtungssystems 5 der Projektionsbelichtungsanlage 1. Beleuchtet wird die erste Rasteranordnung 12 mit insgesamt vier Teilbündeln, die auf der ersten Rasteranordnung 12 an den Ecken einer Raute auftreffen. Im zentralen Rasterbereich 29 treffen dabei zwei Teilbündel 25 auf, die in der y-Richtung jeweils nahe den beiden Rändern des Rasterbereichs 29 liegen. In den Rasterbereichen 27 und 31 trifft jeweils eines der Teilbündel 25 in der y-Richtung mittig auf die erste Rasteranordnung 12 auf. Aufgrund der unterschiedlichen Typen I und III der Rasterelemente 24 erfolgt bei dieser Quadrupol-Beleuchtung eine Kompensation einer aufgrund anderer optischer Komponenten der Projektionsbelichtungsanlage 1 herrührenden Variation einer Elliptizität der Beleuchtung des Objektfeldes 3.

Die Elliptizität ist eine Messgröße zur Beurteilung der Qualität der Ausleuchtung des Objektfeldes 3 in der Objektebene 4. Die Bestimmung der Elliptizität erlaubt dabei eine genauere Aussage über die Verteilung der Energie bzw. Intensität über eine Eintrittspupille des Projektionsobjektivs 21. Hierzu wird die Eintrittspupille des Projektionsobjektivs 21 in acht Oktanten unterteilt, die wie mathematisch üblich entgegen dem Uhrzeigersinn von $O_1$ bis $O_8$ durchnumeriert sind. Der Energie- bzw. Intensitätsbeitrag, den die Oktanten $O_1$ bis $O_8$ der Eintrittspupille zur Beleuchtung eines Feldpunktes beitragen, wird nachfolgend als Energie- bzw. Intensitätsbeitrag $I_1$ bis $I_8$ bezeichnet.

Man bezeichnet als -45°/45°-Elliptizität (Elly, $E_{-45°/45°}$) nachfolgende Größe

$$E_{-45°/45°} = \frac{I1 + I2 + I5 + I6}{I3 + I4 + I7 + I8}$$

und als 0°/90°-Elliptizität (Ellx, $E_{0°/90°}$) nachfolgende Größe

$$E_{0°/90°} = \frac{I1 + I8 + I4 + I5}{I2 + I3 + I6 + I7}.$$

Die asphärische Form der ersten Rasterelemente 24 wird durch einen mehrstufigen Formprozess erzeugt.

Hierbei wird zunächst die Rasteranordnung 12 mit Rasterelementen 24 mit ein und derselben konischen Konstante hergestellt. Anschließend wird eine gewünschte Variation der konischen Konstanten und damit die Ausbildung der verschiedenen Typen I, II, III durchgeführt. Hierbei ergibt sich auch der jeweilige Unterschied in den Linsenradien der Typen I bis III und damit deren unterschiedliche brechende Wirkung. Alternativ ist es möglich, die Rasteranordnung 12 mit den verschiedenen Linsenradien der Typen I bis III in einem einzigen Fertigungsschritt zu strukturieren.

Fig. 5 zeigt eine weitere elementweise abgestufte Ausführung eines Rastermoduls 13. Komponenten und Wirkungen, die denjenigen entsprechen, die vorstehend unter Bezugnahme auf die Ausführung nach den Fig. 1 bis 4 bereits erläutert wurden, tragen die gleichen Bezugsziffern und werden nicht nochmals im Einzelnen diskutiert.

Bei der Ausführung des Rastermoduls 13 nach Fig. 5 ist die erste Rasteranordnung 12 dachfirstartig elementweise abgestuft. Es resultiert im zentralen Rasterbereich 29 ein geringster Abstand $\Delta_I$ zwischen den zugeordneten Rasterelementen 24 und 26 und randseitig ein größter Abstand $\Delta_{III}$ zwischen den zugeordneten Rasterelementen 24 und 26. Analog zu dem, was vorstehend im Zusammenhang mit der Ausführung nach Fig. 2 bereits erläutert wurde, erfolgt auch hier eine Abstandskompensation der unterschiedlichen einschnürenden Wirkungen der Typen I und III der Rasterelemente 24 auf die Teilbündel $25_I$ und $25_{III}$), so dass diese auf den Rasterelementen 26 der zweiten Rasteranordnung 15 wiederum die gleiche x-Erstreckung $x_0$ aufweisen. Es resultiert die gleiche Offset-Kompensation der unterschiedlichen Intensitätsverläufe, die vorstehend im Zusammenhang mit der Fig. 4 bereits diskutiert wurde.

Fig. 6 zeigt eine weitere Variante eines Rastermoduls 13. Komponenten und Wirkungen, die denjenigen entsprechen, die vorstehend unter Bezugnahme auf die Ausführung nach den Fig. 1 bis 5 bereits erläutert wurden, tragen die gleichen Bezugsziffern und werden nicht nochmals im Einzelnen diskutiert.

Die Rasteranordnung 12 nach Fig. 6 ist invertiert dachfirstartig ausgeführt, hat also im Bereich des Zentrums eine geringste Stärke $S_3$ und randseitig eine größte Stärke $S_1$. Zudem sind bei der Ausführung der ersten Rasteranordnung 12 nach Fig. 6 die Typen I bis III der ersten Rasterelemente 24 invertiert über die x-Dimension der ersten Rasteranordnung 12 verteilt.

Zentral, also im Rasterbereich 29, liegt der Typ III mit der schwächsten brechenden Wirkung vor. Randseitig, also in den Rasterbereichen 27, 31, liegen die Rasterelemente 24 des Typs I, also die am stärksten brechenden Rasterelemente 24, vor. Dazwischen, also in den Rasterbereichen 28 und 30, sind wiederum die Rasterelemente 24 des Typs II angeordnet. Auch die Rasteranordnung 12 nach Fig. 6 liegt elementweise abgestuft mit Abstandsstufen 36 vor.

Der im Vergleich zum Abstand $\Delta_I$ große Abstand $\Delta_{III}$ kompensiert die im Vergleich zum Typ I geringere brechende Wirkung des Typs III, so dass auch beim Rastermodul 13 nach Fig. 6 unabhängig vom Typ I bis III auf den Rasterelementen 26 die Teilbündel $25_I$ bis $25_{III}$ mit der gleichen x-Erstreckung $x_0$ vorliegen.

Fig. 7 zeigt eine weitere Variante eines Rastermoduls 13. Komponenten und Wirkungen, die denjenigen entsprechen, die vorstehend unter Bezugnahme auf die Ausführung nach den Fig. 1 bis 6 bereits erläutert wurden, tragen die gleichen Bezugsziffern und werden nicht nochmals im Einzelnen diskutiert.

Bei der Fig. 7 liegt im Unterschied zum Rastermodul 13 nach Fig. 6 nicht die erste Rasteranordnung 12, sondern die zweite Rasteranordnung 15 als invers dachfirstartig ausgebildetes Element mit zentral geringster Stärke $S_{III}$ und randseitig größter Stärke $S_I$ vor. Es resultiert eine entsprechende kompensatorische Wirkung der Abstände $\Delta_I$ und $\Delta_{III}$ auf die Teilbündel $25_I$ und $2_{III}$, wie vorstehend im Zusammenhang mit dem Rastermodul 13 nach Fig. 6 bereits erläutert.

Fig. 8 zeigt eine weitere Variante eines Rastermoduls 13. Komponenten und Wirkungen, die denjenigen entsprechen, die vorstehend unter Bezugnahme auf die Ausführung nach den Fig. 1 bis 7 bereits erläutert wurden, tragen die gleichen Bezugsziffern und werden nicht nochmals im Einzelnen diskutiert.

Beim Rastermodul 13 nach Fig. 8 liegen beide Rasteranordnungen 12, 15 dachfirstartig elementweise abgestuft vor. Die beiden Dachfirste der Rasteranordnungen 12, 15 sind einander zugewandt, so dass im Rasterbereich 29 ein geringster Abstand $\Delta_I$ und randseitig ein größter Abstand $\Delta_{III}$ zwischen den Rasterelementen 24, 26 vorliegt. Die Anordnung des Rastermoduls 13 nach Fig. 8 wird dann gewählt, wenn die Typen I und III einen im Vergleich zur Anordnung nach den Fig. 2 und 5 stärkeren Unterschied in ihrer brechenden Wirkung haben.

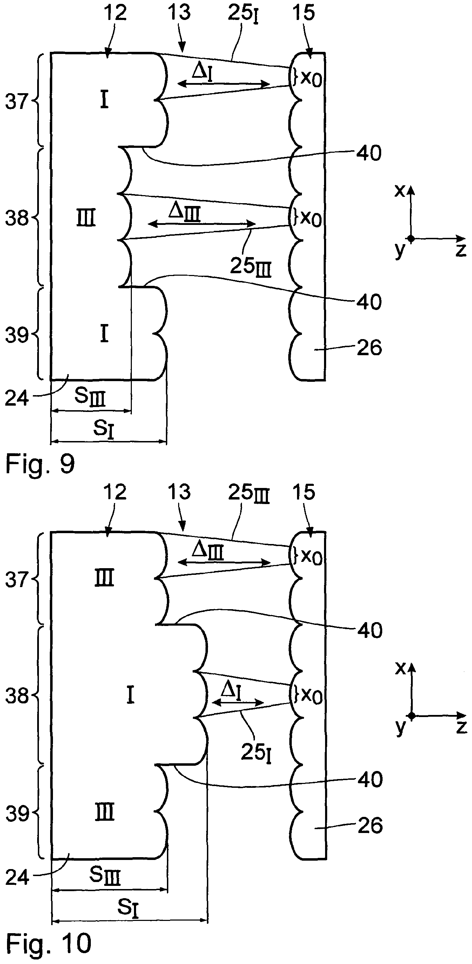

Fig. 9 zeigt eine weitere Variante eines Rastermoduls 13. Komponenten und Wirkungen, die denjenigen entsprechen, die vorstehend unter Bezugnahme auf die Ausführung nach den Fig. 1 bis 8 bereits erläutert wurden, tragen die gleichen Bezugsziffern und werden nicht nochmals im Einzelnen diskutiert.

Bei der Ausführung nach Fig. 9 liegen anders als bei den vorstehend beschriebenen Ausführungen nach den Fig. 2 sowie 5 bis 8 lediglich drei Rasterbereiche, nämlich die Rasterbereiche 37, 38 und 39 vor. Die erste Rasteranordnung 12 des Rastermoduls 13 nach Fig. 9 hat in der schematischen Darstellung nach Fig. 9 in der x-Richtung wiederum insgesamt sieben der ersten Rasterelemente 24. Die Rasterelemente 24 in den Rasterbereichen 37 und 39 gehören zum stärker brechenden Typ I. Die Rasterelemente 24 der ersten Rasteranordnung 12 im zentralen Rasterbereich 38 gehören zum schwächer brechenden Typ III. In den Rasterbereichen 37 und 39 liegen jeweils zwei Rasterelemente 24 des Typs I vor. Im Rasterbereich 38 liegen drei nebeneinander liegende Rasterelemente 24 des Typs III vor.

Zwischen den Rasterbereichen 37 und 38 einerseits und zwischen den Rasterbereichen 38 und 39 andererseits weist die erste Rasteranordnung 12 jeweils eine Abstandsstufe 40 auf. Ein Abstand $\Delta_I$ zwischen den Rasterelementen 24 im Rasterbereich 37 und den zugeordneten Rasterelementen 26 der zweiten Rasteranordnung 15 ist kleiner als ein

Abstand $\Delta_{III}$ der ersten Rasterelemente 24 im Rasterbereich 38 und den zugeordneten zweiten Rasterelementen 26. Es ergibt sich eine entsprechende Kompensation der unterschiedlichen brechenden Wirkungen der Typen I und III über die unterschiedlichen Abstände $\Delta_I$ und $\Delta_{III}$, wie vorstehend im Zusammenhang mit dem Rastermodul 13 nach Fig. 6 bereits erläutert.

Fig. 10 zeigt eine weitere Variante eines Rastermoduls 13. Komponenten und Wirkungen, die denjenigen entsprechen, die vorstehend unter Bezugnahme auf die Ausführungen nach den Fig. 1 bis 8 und insbesondere nach der Fig. 9 bereits erläutert wurden, tragen die gleichen Bezugsziffern und werden nicht nochmals im Einzelnen diskutiert.

Beim Rastermodul 13 nach Fig. 10 ist die erste Rasteranordnung 12 invers zur Rasteranordnung 12 nach Fig. 9 ausgeführt. Im zentralen Rasterbereich 38 liegen die Rasterelemente 24 des stärker brechenden Typs I und in den randseitigen Rasterbereichen 37 und 39 liegen die Rasterelemente 24 des schwächer brechenden Typs III vor. Aufgrund des im Vergleich zum Abstand $\Delta_I$ nun randseitig größeren Abstandes $\Delta_{III}$ ergibt sich eine kompensatorische Wirkung, wie im Zusammenhang mit der Ausführung des Rastermoduls 13 nach Fig. 5 bereits erläutert.

Bei der mikrolithographischen Herstellung eines mikro- bzw. nanostrukturierten Bauelements mit der Projektions-Belichtungsanlage 1 wird ein Substrat bereitgestellt, auf das zumindest teilweise eine Schicht aus einem lichtempfindlichen Material aufgebracht ist. Bei dem Substrat handelt es sich in der Regel um einen Wafer. Weiterhin wird ein Retikel bereitgestellt, das die abzubildenden Strukturen aufweist. Mit der Projektions-Belichtungsanlage 1 wird dann wenigstens ein Teil des Retikels auf einen Bereich der lichtempfindlichen Schicht auf dem Substrat projiziert.

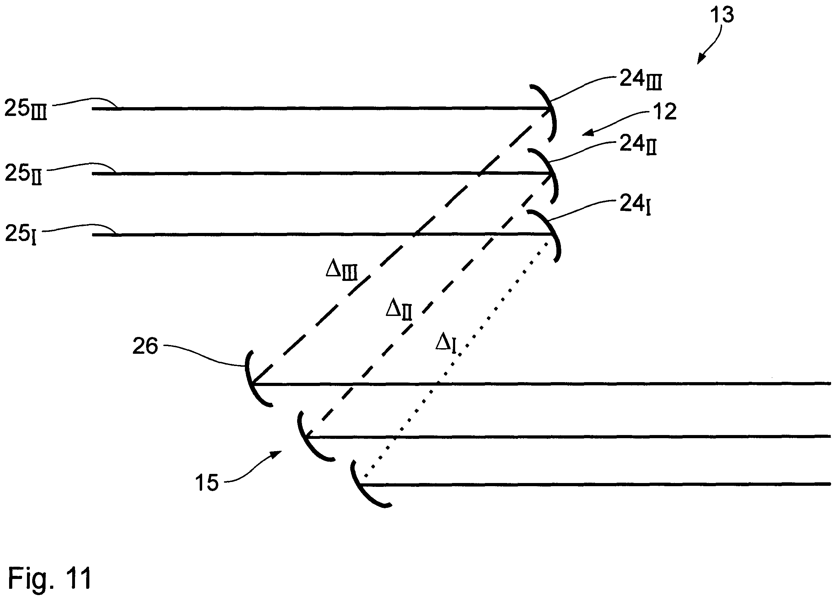

Anhand der Fig. 11 wird nachfolgend eine weitere Variante eines Rastermoduls 13 erläutert. Komponenten und Wirkungen, die denjenigen entsprechen, die vorstehend unter Bezugnahme auf die Ausführungen nach den Fig. 1 bis 10 bereits erläutert wurden, tragen die gleichen Bezugsziffern und werden nicht nochmals im Einzelnen diskutiert.

Beim Rastermodul 13 nach Fig. 11 sind die beiden Rasteranordnungen 12, 15 mit reflektierenden ersten Rasterelementen 24 und mit reflektierenden zweiten Rasterelementen 26 ausgeführt. Anstelle einer unterschiedlichen brechenden Wirkung haben die Rasterelemente 24 der ersten Rasteranordnung 12 bei der Ausführung nach Fig. 11 eine über ihre Reflexion unterschiedliche bündelbeeinflussende Wirkung. So kann das in der Fig. 11 zuoberst dargestellte Rasterelement $24_{III}$ des Typs III eine am wenigsten stark ein Teilbündel $25_{III}$ bündelnde Wirkung haben und das in der Fig. 11 unten dargestellte Rasterelement $24_I$ des Typs I kann eine das Teilbündel $25_I$ am stärksten bündelnde Wirkung haben. Die bündelnde Wirkung des dazwischen dargestellten Rasterelements $24_{II}$ auf das Teilbündel $25_{II}$ liegt zwischen den beiden bündelnden Wirkungen der Rasterelemente $24_I$ und $24_{III}$.

Die beiden Rasteranordnungen 12, 15 sind räumlich so zueinander angeordnet, dass für eine optische Weglänge $\Delta$ zwischen einem der ersten Rasterelemente 24 und einem diesem zugeordneten zweiten Rasterelement 26 der zweiten Rasteranordnung 15 folgende Relation gilt:

$$\Delta_I < \Delta_{II} < \Delta_{III}.$$

Es resultiert aufgrund dieser individuellen Abstandszuordnung $\Delta_I$ bis $\Delta_{III}$ zum Typ I bis III des ersten Rasterelements 24 eine kompensierende Wirkung, wie vorstehend beispielsweise im Zusammenhang mit dem Rastermodul 13 nach Fig. 2 bereits erläutert.

Die beiden Rasteranordnungen 12, 15 der vorstehend erläuterten Ausführungsformen können auch in umgekehrter Reihenfolge im Strahlengang des Beleuchtungslichts 8 angeordnet sein.

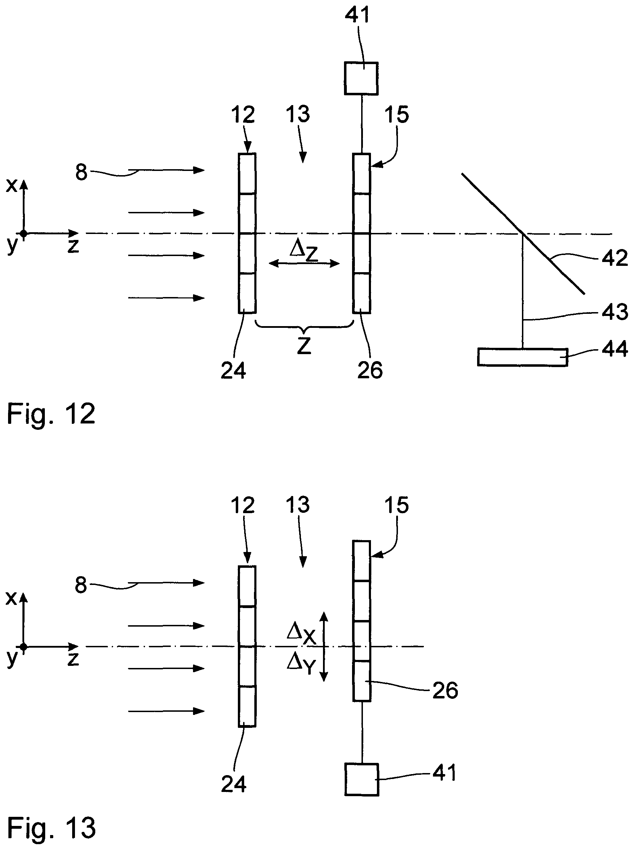

Fig. 12 zeigt schematisch eine weitere Ausführung des Rastermoduls 13 mit Rasteranordnungen 12, 15 mit Rasterelementen 24, 26. Komponenten und Funktionen, die denjenigen entsprechen, die vorstehend unter Bezugnahme auf die Ausführungen nach den Fig. 1 bis 11 bereits erläutert wurden, tragen die gleichen Bezugsziffern und werden nicht nochmals im Einzelnen diskutiert.

Beim Rastermodul 13 nach Fig. 12 sind die beiden Rasteranordnungen 12, 15 in der z-Richtung, also senkrecht zu den von den beiden Rasteranordnungen 12, 15 aufgespannten xy-Ebenen, links eines Verstellweges $\Delta_Z$ verlagerbar. Bei der in der Fig. 12 dargestellten Ausführung wird hierzu die zweite Rasteranordnung 15 in der z-Richtung verlagert. Hierzu ist die zweite Rasteranordnung 15 mit einer Verlagerungseinrichtung 41 mechanisch verbunden. Hierbei kann es sich um eine zur Verlagerung optischer Komponenten gebräuchliche Linear-Verstelleinheit oder um einen mikromechanischen Aktor handeln.

Im Strahlengang nach der zweiten Rasteranordnung 15 ist ein für das Beleuchtungslicht 8 teildurchlässiger Auskoppelspiegel 42 angeordnet. Über diesen wird ein Teilstrahl 43 des Beleuchtungslichts 8 hin zu einem ortsempfindlichen Detektor 44, beispielsweise hin zu einem CCD-Array, geleitet. Über eine nicht in der Zeichnung dargestellte zentrale Steuereinrichtung steht der Detektor 44 mit der Verlagerungseinrichtung 41 in Signalverbindung. Der Detektor 44 erfasst eine Beleuchtungsintensitätsverteilung des Teilstrahls 43, aus der auf eine Beleuchtungsintensitätsverteilung und/oder auf eine Beleuchtungswinkelverteilung des Beleuchtungslichts 8 in der Objektebene 4 geschlossen werden kann.

Über die $\Delta_Z$-Verlagerung der Rasteranordnung 15 relativ zur Rasteranordnung 12 lässt sich eine Offset-Korrektur der Intensität über das genutzte Objektfeld 3 erreichen, wie vorstehend im Zusammenhang mit der Fig. 4 bereits erläutert. Je größer ein Abstand Z zwischen den beiden Rasteranordnungen 12, 15 ist, desto kleiner ist eine x-Erstreckung des Beleuchtungsfeldes, so dass die Intensität im Objektfeld 3 stärker konzentriert wird.

Weiterhin lässt sich über die $\Delta_Z$-Verlagerung ein Offset der Elliptizität, also beispielsweise der Größen $E_{-45°/45°}$ und/oder $E_{0°/90°}$ herbeiführen, die vorstehend bereits diskutiert wurden. Auch eine Uniformität (uniformity) einer Ausleuchtung des Objektfelds 3 lässt sich über die $\Delta_Z$-Verlagerung einstellen. Die Uniformität ist definiert als die normierte scanintegrierte Gesamtenergie SE (x) an einem x-Wert im Objektfeld 3, also an einer Feldhöhe. Es gilt für die Uniformität U:

$$U \text{ (in Prozent)} = 100 \, (SE \, (x_{max}) - SE \, (x_{min}))/(SE \, (x_{max}) + SE \, (x_{min}))$$

SE $(x_{max})$ ist hierbei die Gesamtenergie am x-Wert $x_{max}$, an dem die höchste scanintegrierte Gesamtenergie vorliegt. SE $(x_{min})$ ist hierbei die Gesamtenergie am x-Wert $x_{min}$, an dem die kleinste scanintegrierte Gesamtenergie vorliegt.

Weiterhin lässt sich über die $\Delta_Z$-Verlagerung eine Offset-Korrektur einer Telezentrie herbeiführen.

Die Telezentrie ist eine Messgröße für eine Beleuchtungswinkel-Schwerpunktlage der Energie bzw. Intensität der Beleuchtungslichtbeaufschlagung des Objektfeldes 3.

In jedem Feldpunkt des ausgeleuchteten Objektfeldes ist ein Schwerstrahl eines diesem Feldpunkt zugeordneten Lichtbüschels definiert. Der Schwerstrahl hat dabei die energiegewichtete Richtung des von diesem Feldpunkt ausgehenden Lichtbüschels. Im Idealfall verläuft bei jedem Feldpunkt der Schwerstrahl parallel zum von der Beleuchtungsoptik bzw. dem Projektionsobjektiv 21 vorgegebenen Hauptstrahl.

Die Richtung des Hauptstrahls $\vec{s}_0$ (x,y) ist anhand der Designdaten der Beleuchtungsoptik bzw. des Projektionsobjektivs 21 bekannt. Der Hauptstrahl ist an einem Feldpunkt definiert durch die Verbindungslinie zwischen dem Feldpunkt und dem Mittelpunkt der Eintrittspupille des Projektionsobjektivs 21. Die Richtung des Schwerstrahls an einem Feldpunkt x, y im Objektfeld in der Objektebene 4 berechnet sich zu:

$$\vec{s}(x, y) = \frac{1}{\widetilde{E}(x, y)} \int du \, dv \begin{pmatrix} u \\ v \end{pmatrix} E(u, v, x, y).$$

E (u,v,x,y) ist die Energieverteilung für den Feldpunkt x,y in Abhängigkeit von den Pupillenkoordinaten u,v, also in Abhängigkeit vom Beleuchtungswinkel, den der entsprechende Feldpunkt x, y sieht.

$\widetilde{E}(x, y) = \int du \, dv \, E(u, v, x, y)$ ist dabei die Gesamtenergie, mit der der Punkt x,y beaufschlagt wird.

Ein z. B. mittiger Objektfeldpunkt $x_0$, $y_0$ sieht die Strahlung von Strahlungs-Teilbündeln aus Richtungen u, v, die durch die Position der jeweiligen Rasterelemente 26 auf der zweiten Rasteranordnung 15 definiert ist. Der Schwerstrahl s verläuft bei dieser Beleuchtung nur dann längs des Hauptstrahls, wenn sich die verschiedenen Energien bzw. Intensitäten der den Rasterelementen 26 zugeordneten Strahlungs-Teilbündel bzw. Ausleuchtungskanäle zu einer über alle Rasterelemente 26 integrierten Schwerstrahlrichtung zusammensetzen, die parallel zu einer Hauptstrahlrichtung des Beleuchtungslichts 8 verläuft. Dies ist nur im Idealfall so. In der Praxis existiert eine Abweichung zwischen der Schwerstrahlrichtung $\vec{s}(x, y)$ und der Hauptstrahlrichtung $\vec{s}_0(x,y)$, die als Telezentriefehler $\vec{t}(x, y)$ bezeichnet wird:

$$\vec{t}(x, y) = \vec{s}(x, y) - \vec{s}_0(x, y)$$

Korrigiert werden muss im praktischen Betrieb der Projektionsbelichtungsanlage 1 nicht der lokale Telezentriefehler an einem bestimmten Objektfeldort (x, y), sondern der bei x = $x_0$ scanintegrierte Telezentriefehler. Dieser ergibt sich zu:

$$\vec{T}(x_0) = \frac{\int dy \, \widetilde{E}(x_0, y) \vec{t}(x_0, y)}{\int dy \, \widetilde{E}(x_0, y)}.$$

Es wird also der Telezentriefehler korrigiert, den ein durch das Objektfeld 3 in der Objektebene 4 während des Scannens laufender Punkt (x, z. B. $x_0$) auf dem Retikel ernergiegewichtet aufintegriert erfährt. Unterschieden kann dabei zwischen einem x-Telezentriefehler und einem y-Telezentriefehler werden. Der x-Telezentriefehler $T_x$ ist als Abweichung des Schwerstrahls vom Hauptstrahl senkrecht zur Scanrichtung, also über die Feldhöhe, definiert. Der y-Telezentriefehler $T_y$ ist als die Abweichung des Schwerstrahls vom Hauptstrahl in Scanrichtung definiert.

Über den Detektor 44, die zentrale Steuereinrichtung und die Verlagerungseinrichtung 41 ist eine Regelung der Beleuchtungsparameter möglich, so dass das Rastermodul 13 als Korrekturelement arbeiten kann, das im Betrieb zu einer Nachführung von Istwerten der Beleuchtungsparameter an vorgegebene Sollwerte genutzt werden kann. Hierzu wertet die zentrale Steuereinrichtung die vom Detektor 44 ermittelten Beleuchtungsparameter des Teilstrahls 43 aus, aus denen auf die Beleuchtungsparameter des Beleuchtungslichts 8 zurückgeschlossen werden kann. Je nach den auf diese Weise ermittelten Istwerten der Beleuchtungsparameter erfolgt dann eine Verstellung der zweiten Rasteranordnung 15 mit Hilfe einer entsprechenden Ansteuerung der Verlagerungseinrichtung 41 über die zentrale Steuereinrichtung.

Fig. 13 zeigt in einer zu Fig. 12 ähnlichen Darstellung eine weitere Ausführung eines Rastermoduls 13 mit anderen Verlagerungs-Freiheitsgraden zwischen den beiden Rasteranordnungen 12 und 15. Komponenten, die denjenigen entsprechen, die vorstehend unter Bezugnahme auf die vorstehend beschriebenen Ausführungen und insbesondere unter Bezugnahme auf die Ausführung nach Fig. 12 bereits erläutert wurden, tragen die gleichen Bezugsziffern und werden nicht nochmals im Einzelnen diskutiert.

Beim Rastermodul 13 nach Fig. 13 kann das zweite Rastermodul 15 relativ zum ersten Rastermodul 12 längs Verstellwegen $\Delta_X$, $\Delta_Y$ in der x-Richtung und in der y-Richtung verlagert werden. Hierzu hat das Rastermodul 13 wiederum eine Verlagerungseinrichtung 41, die mechanisch an das zweite Rastermodul 15 angekoppelt ist.

Über eine $\Delta_X$ bzw. $\Delta_Y$-Verlagerung der zweiten Rasteranordnung 15 relativ zur ersten Rasteranordnung 12 lässt sich eine relative x- bzw. y-Position des Beleuchtungsfeldes zum Objektfeld 3 vorgeben. Eine Kipp-Abhängigkeit der Telezentrie über die Feldhöhe x, ein sogenannter Telezentrietilt, sowie eine Kipp-Abhängigkeit der Elliptizität über die Feldhöhe x können durch eine $\Delta_X$ bzw. $\Delta_Y$-Verlagerung ebenfalls eingestellt werden.

Über eine zusätzliche $\Delta_Z$-Verlagerung, die beim Rastermodul 13 nach Fig. 13 entsprechend den Ausführungen zum Rastermodul 13 nach Fig. 12 ebenfalls vorhanden sein kann, lässt sich beispielsweise zusammenwirkend mit einer $\Delta_X$ bzw. $\Delta_Y$-Verlagerung ein Intensitäts-Offset des Beleuchtungslichts 8 über das Objektfeld 3 einstellen.

Wenn das Rastermodul eine Rasteranordnung, beispielsweise die Rasteranordnung 12, mit Unterteilung in Rasterbereiche mit unterschiedlicher bündelbeeinflussender Wirkung, beispielsweise entsprechend den Rasterbereichen 27 bis 31 nach Fig. 3 aufweist, führt eine $\Delta_X$ bzw. $\Delta_Y$-Verlagerung zu einer Kipp-Veränderung der Elliptizität über das Objektfeld 3. Dies kann zur Einstellung eines Ellipsentilts über die Feldhöhe x genutzt werden.

Auch das Rastermodul 13 nach Fig. 13 kann eine Parameterregelung über einen Detektor und die zentrale Steuereinrichtung aufweisen, wie vorstehend im Zusammenhang mit dem Rastermodul 13 nach Fig. 12 erläutert.

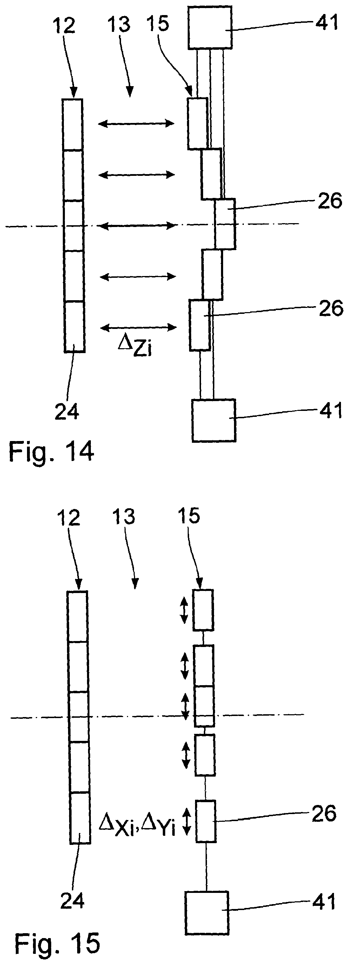

Fig. 14 zeigt in einer zu Fig. 12 ähnlichen Darstellung eine weitere Ausführung eines Rastermoduls 13 mit anderen Verlagerungs-Freiheitsgraden zwischen den beiden Rasteranordnungen 12 und 15. Komponenten, die denjenigen entsprechen, die vorstehend unter Bezugnahme auf die vorstehend beschriebenen Ausführungen und insbesondere unter Bezugnahme auf die Ausführung nach Fig. 12 bereits erläutert wurden, tragen die gleichen Bezugsziffern und werden nicht nochmals im Einzelnen diskutiert.

Beim Rastermodul 13 nach Fig. 14 ist wiederum die zweite Rasteranordnung 15 relativ zur ersten Rasteranordnung 12 längs der z-Richtung verlagerbar. Hierbei sind die einzelnen Rasterelemente 26 der zweiten Rasteranordnung 15 individuell und unabhängig voneinander um Verstellwege $\Delta_{Z1}$, $\Delta_{Z2}$..., $\Delta_{ZN}$ verlagerbar. Jedes der Rasterelemente 26 ist dabei mit einer zugeordneten Verstelleinrichtung 41 mechanisch gekoppelt, wie dies in der Fig. 14 schematisch angedeutet ist. Die Verlagerungseinrichtungen 41 sorgen für die individuelle Verlagerung der Rasterelemente 26 in der z-Richtung. Jedem der Rasterelemente 26 kann eine eigene Verlagerungseinrichtung 41 zugeordnet sein. Die Verlagerung der Rasterelemente 26 über die Verlagerungseinrichtungen 41 wird wiederum über die nicht dargestellte zentrale Steuereinrichtung gesteuert. Auch beim Rastermodul 13 nach Fig. 14 kann eine Beleuchtungsparameterregelung über einen Detektor und die zentrale Steuereinrichtung erfolgen, wie vorstehend im Zusammenhang mit dem Rastermodul 13 nach Fig. 12 erläutert.

Durch die lokale Variation der Abstände $\Delta_{Zi}$ wird abhängig von der Position des jeweils z-verlagerten Rasterelements 26 eine mit dem zugehörigen Ausleuchtungskanal vorgegebene Größe des zu diesem Ausleuchtungskanal gehörenden Beleuchtungsfeld-Anteils einstellbar vorgegeben. Es ergibt sich eine Einstellmöglichkeit für den Ellipsenoffset. Ein Verlauf der Ellipse über das Objektfeld 3 kann beispielsweise durch eine Variation der Abstände $\Delta_{Zi}$ mit vorgegebener Verteilung beeinflusst werden. Hierdurch ist die Möglichkeit einer Korrektur der Ellipse gegeben. Auch die Uniformität kann durch eine Variation der Abstände $\Delta_{Zi}$ eingestellt werden.

Die vorstehend erläuterten Verlagerungseinrichtungen 41 können bei den Rastermodulen 13 nach den Fig. 12 bis 14 so ausgeführt sein, dass eine periodische Verlagerung mindestens eines Abschnitts der ersten Rasteranordnung 12, also mindestens eines der Rasterelemente 24, einer Gruppe der Rasterelemente 24 oder der gesamten ersten Rasteranordnung 12, relativ zumindest einem Abschnitt der zweiten Rasteranordnung 15, also relativ zumindest

einem Rasterelement 26, zumindestens einer Gruppe von Rasterelementen 26 oder relativ zur gesamten zweiten Rasteranordnung 15, mit einer Periode stattfindet, die klein ist gegenüber einer Beleuchtungsdauer des Objekt- bzw. Beleuchtungsfeldes 3. Eine Verlagerungseinrichtung 41, die eine derartige periodische Verlagerung ermöglicht, wird auch als Wobbler bezeichnet.

Ein derartiger Wobbler verlagert die Rasteranordnung 15 oder Abschnitte hiervon mit einer derartigen Zeitkonstante, dass sich eine Verschiebung der Ausleuchtungskanäle bei jedem Lichtpuls ergibt, den die primäre Lichtquelle 6 erzeugt. Während der Beleuchtungsdauer der Belichtung eines bestimmten Abschnitts auf einem mit der Projektionsbelichtungsanlage 1 zu belichtenden Wafer erreichen diesen Abschnitt beispielsweise 30 Beleuchtungsimpulse der Lichtquelle 6. Während dieser 30 Beleuchtungsimpulse kann eine periodische Verlagerung des Wobblers erfolgen.

Fig. 15 zeigt in einer zu Fig. 12 ähnlichen Darstellung eine weitere Ausführung eines Rastermoduls 13 mit anderen Verlagerungs-Freiheitsgraden zwischen den beiden Rasteranordnungen 12 und 15. Komponenten, die denjenigen entsprechen, die vorstehend unter Bezugnahme auf die vorstehend beschriebenen Ausführungen und insbesondere unter Bezugnahme auf die Ausführung nach Fig. 12 bereits erläutert wurden, tragen die gleichen Bezugsziffern und werden nicht nochmals im Einzelnen diskutiert.

Eine Verlagerungseinrichtung 41 für die Rasterelemente 26 der zweiten Rasteranordnung 15 gewährleistet eine individuelle x-, y-Verlagerung der Rasterelemente 26 innerhalb von Verlagerungswegen $\Delta_{X1}, \Delta_{X2}..., \Delta_{XN}$ bzw. $\Delta_{Y1}, \Delta_{Y2} ..., \Delta_{YN}$. Diese x-, y-Verlagerung führt zu einer pupillenabhängigen Verschiebung der Ausleuchtungskanäle, die sich im Objektfeld 3 verlagern. Dies kann zur Optimierung einer Überlagerung der Ausleuchtungskanäle im Objektfeld 3 und damit zu einer Optimierung der Intensitätsverteilung über das Objektfeld 3 genutzt werden. Die x- bzw. y-Verlagerung $\Delta_{Xi}, \Delta_{Yi}$ führt zu einer Kippabhängigkeit der Intensitätsverteilung des jeweiligen Ausleuchtungskanals des verstellten Rasterelements 26, was entsprechende Auswirkungen auf die Uniformität hat. Hierüber ist eine Korrektur einer Kipp-Abhängigkeit der Telezentrie möglich.

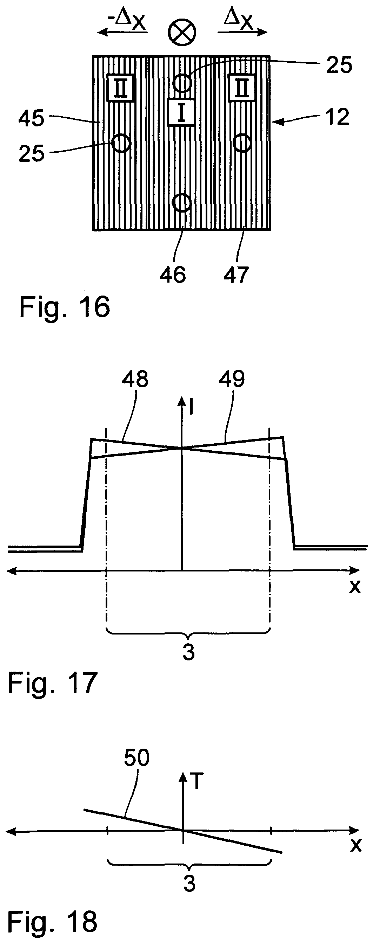

Die Auswirkungen einer x-Verschiebung von Rasterbereichen einer ersten Rasteranordnung 12 wird nachfolgend anhand der Fig. 16 bis 18 näher erläutert. Komponenten bzw. Funktionen, die denjenigen entsprechen, die vorstehend unter Bezugnahme auf die Fig. 1 bis 15 bereits diskutiert wurden, tragen die gleichen Bezugsziffern und werden nicht nochmals im Einzelnen erläutert.

Die erste Rasteranordnung 12 nach Fig. 16 hat drei Rasterbereiche 45, 46, 47, die sich entsprechend dem, was vorstehend unter Bezugnahme auf die Rasterbereiche 27 bis 31 der ersten Rasteranordnung 12 nach Fig. 3 erläutert wurde, in ihrer bündelbeeinflussenden Wirkung unterscheiden, also beispielsweise Rasterelemente 24 mit unterschiedlichen konischen Konstanten aufweisen.

Ausgehend von einer Grundstellung der drei Rasterbereiche 45 bis 47 zueinander wird der in der Fig. 16 linke Rasterbereich 45 gegenüber dem mittleren Rasterbereich 46 um einen Weg $-\Delta_X$ in der Fig. 16 nach links verlagert und der in der Fig. 16 rechte Rasterbereich 47 wird relativ zum stationären mittleren Rasterbereich 46 um einen Weg $\Delta_X$ in der Fig. 16 nach rechts verlagert.

Die beiden Verlagerungen $-\Delta_X, \Delta_X$ führen zu Änderungen im Intensitätsverlauf über das Objektfeld 3, wie in der Fig. 17 dargestellt. Die Fig. 17 zeigt entsprechend der Fig. 4 ein I (x)-Diagramm der scanintegrierten Intensität über die Feldhöhe x. Aufgrund der Verlagerung des Rasterbereichs 45 um den Weg $-\Delta_X$ ergibt sich ein verkippter Intensitätsverlauf 48, wobei die Intensität am in der Fig. 17 linken Rand des Objektfeldes 3 am größten und am in der Fig. 17 rechten Rand des Objektfeldes 3 am geringsten ist. Die Verlagerung des Rasterbereichs 47 um den Weg $\Delta_X$ führt zu einem Intensitätsverlauf 49 mit gegenläufigem Kipp, bei dem die Intensität am in der Fig. 17 linken Feldrand am geringsten und am in der Fig. 17 rechten Feldrand am größten ist.

Aufgrund der verkippten Intensitätsverläufe 48, 49 ergibt sich ein Telezentrieverlauf 50 über das Objektfeld 3 gemäß Fig. 18. Dies liegt daran, dass am in der Fig. 18 linken Rand des Objektfeldes 3 die Intensitätsbeaufschlagung vom Rasterbereich 47 dominiert und am in der Fig. 18 rechten Rand des Objektfeldes 3 die Intensitätsbeaufschlagung vom Rasterbereich 45.

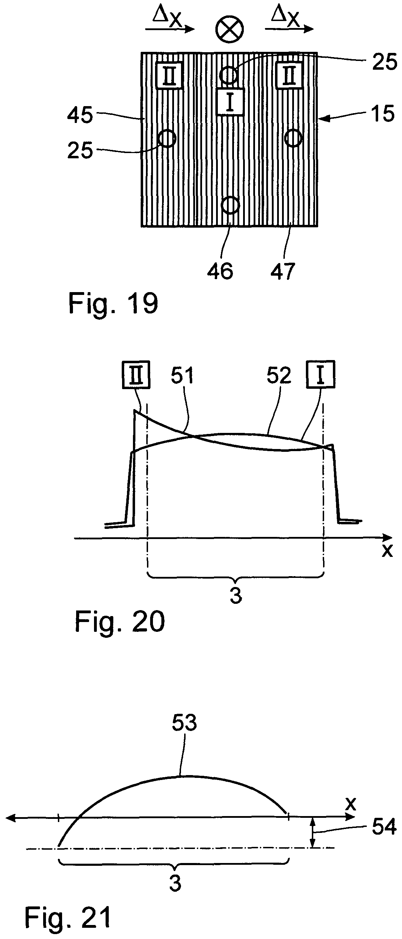

Anhand der Fig. 19 bis 21 wird der Effekt einer relativen Verlagerung von Rasterbereichen 45, 47 zum stationären mittleren Rasterbereich 46 der zweiten Rasteranordnung 15 auf bestimmte Beleuchtungsparameter der Beleuchtung des Objektfeldes 3 erläutert. Komponenten, die denjenigen entsprechen, die vorstehend unter Erläuterung auf die Fig. 1 bis 18 und insbesondere unter Bezugnahme auf die Fig. 16 bis 18 bereits diskutiert wurden, tragen die gleichen Bezugsziffern und werden nicht nochmals im Einzelnen beschrieben.

Im Unterschied zur Fig. 16, wo die erste Rasteranordnung 12 dargestellt ist, ist in der Fig. 19 die zweite Rasteranordnung 15 dargestellt.

Ausgehend wiederum von einer Grundstellung der Rasterbereiche 45 bis 47 zueinander wird bei der Verlagerung nach Fig. 19 der Rasterbereich 45 gegenüber dem Rasterbereich 46 in der Fig. 19 nach rechts um einen Weg $\Delta_X$ und der Rasterbereich 47 wird relativ zum mittleren stationären Rasterbereich 46 ebenfalls um einen Weg $\Delta_X$ verschoben. Die beiden äußeren Rasterbereiche 45, 47 werden also beide relativ zum mittleren Rasterbereich 46 in der gleichen Richtung, nämlich in positiver x-Richtung, verschoben.

Der mittlere Rasterbereich 46 einerseits und die beiden äußeren Rasterbereiche 45, 47 andererseits sind aus Rasterelementen unterschiedlicher bündelbeeinflussender Wirkung aufgebaut. Der mittlere Rasterbereich 46 weist Rasterelemente eines ersten bündelbeeinflussenden Typs I, beispielsweise mit einer ersten konischen Konstante, auf. Die beiden äußeren Rasterbereiche 45, 47 weisen Rasterelemente 26 eines zweiten Typs II mit anderer bündelbeeinflussender Wirkung, insbesondere mit im Vergleich zum Typ I anderer konischer Konstante, auf.

Aufgrund der Verschiebungen $\Delta_X$ der beiden äußeren Rasterbereiche 45, 47 zum mittleren Rasterbereich 46 ergibt sich ein Kipp der feldabhängigen Intensitätsverteilung des Typs II derart, dass am linken Feldrand eine höhere Intensität ankommt als am rechten Feldrand (vergleiche Intensitätsverlauf 51 in der Fig. 20). Da der mittlere Rasterbereich 46 nicht verlagert wird, ergibt sich keine Änderung von dessen Intensitätsverlauf 52 über das Objektfeld 3.

Aufgrund des Kipps des Intensitätsverlaufs 51 ergibt sich ein entsprechender Kipp eines Elliptizitätsverlaufs 53, der in der Fig. 21 dargestellt ist. Beim dort dargestellten Elliptizitätsverlauf 53 kann es sich um den Verlauf der Elliptizität $E_{-45°/45°}$ oder um den Verlauf der Elliptizität $E_{o°/90°}$ handeln. Der Kipp des Elliptizitätsverlaufs 53 führt am in der Fig. 21 rechten Rand des Objektfeldes 3 zu einem Elliptizitäts-Offset 54.

Die Verstellwege $\Delta_X$, $\Delta_Y$ für die Rasteranordnungen 12, 15 bzw. die Gruppen oder Bereiche von Rasterelementen 24, 26 oder für die einzelnen Rasterelemente 24, 26 können um eine Grundstellung in einen Bereich von - 10 $\mu$m bis + 10 $\mu$m liegen. Die absoluten Gesamt-Verstellwege können also 20 $\mu$m betragen. Ein absoluter $\Delta_Z$-Verstellweg für die Rasteranordnungen 12, 15 bzw. die Gruppen oder Bereiche von Rasterelementen 24, 26 oder für die einzelnen Rasterelemente 24, 26 kann 30 $\mu$m betragen.

Die Verlagerung in der z-Richtung stellt eine Verlagerung im Wesentlichen längs einer Strahlrichtung des Beleuchtungslichts dar. Die x- bzw. y-Verlagerung stellt eine Verlagerung im Wesentlichen quer zur Strahlrichtung des Beleuchtungslichts 8 dar.

Alternativ kann die Verlagerungseinrichtung 41 auch so ausgeführt sein, dass eine der beiden Rasteranordnungen 12, 15 relativ zur anderen der beiden Rasteranordnungen 15, 12 beispielsweise um eine zur x-Achse oder um eine zur y-Achse parallele Schwenkachse schwenkbar ist. In diesem Fall ist die Verlagerungseinrichtung 41 als Schwenkantrieb für zumindest eine der beiden Rasteranordnungen 12, 15 ausgeführt.

Die vorstehend beschriebenen Typen von Rasterelementen können je nach Ausführung des Rastermoduls Teile der ersten Rasteranordnung 12 und/oder Teile der zweiten Rasteranordnung 15 sein.

**Patentansprüche**

1. Beleuchtungssystem (5) für die Mikro-Lithographie zur Beleuchtung eines Beleuchtungsfeldes (3) mit Beleuchtungslicht (8) einer primären Lichtquelle (6),

   - mit einer ersten Rasteranordnung (12) mit bündelformenden ersten Rasterelementen (24), die in einer ersten Ebene (11) des Beleuchtungssystems (5) oder benachbart zu dieser angeordnet sind, zur Erzeugung einer Rasteranordnung sekundärer Lichtquellen,
   - mit einer Übertragungsoptik (15, 17) zur überlagernden Übertragung des Beleuchtungslichts (8) der sekundären Lichtquellen in das Beleuchtungsfeld (3),
   - wobei die Übertragungsoptik (15, 17) eine zweite Rasteranordnung (15) mit bündelformenden zweiten Rasterelementen (26) aufweist,
   - wobei jeweils eines der Rasterelemente (24) der ersten Rasteranordnung (12) einem der Rasterelemente (26) der zweiten Rasteranordnung (15) zur Führung eines Teilbündels (25) eines gesamten Bündels des Beleuchtungslichts (8) zugeordnet ist,
   - wobei aufgrund der bündelformenden Wirkung der ersten Rasterelemente (24) der ersten Rasteranordnung (12) das Beleuchtungslicht (8) in eine der Anzahl der beleuchteten ersten Rasterelemente (24) entsprechende Anzahl von Teilbündeln (25) aufgeteilt wird,
   - wobei die zweiten Rasterelemente (26) der zweiten Rasteranordnung (15) zur Führung des jeweiligen Teilbündels (25) den ersten Rasterelementen (24) der ersten Rasteranordnung (12) zugeordnet sind,

   **dadurch gekennzeichnet, dass**

   - mindestens eine der beiden Rasteranordnungen (12) mindestens zwei Typen (I, II, III) der Rasterelemente (24) aufweist, die sich in ihrer bündelbeeinflussenden Wirkung unterscheiden, wobei es sich bei der bündelbeeinflussenden Wirkung um einen sammelnden Effekt handelt,
   - wobei die Rasterelemente (24, 26) der beiden Rasteranordnungen (12, 15) so zueinander angeordnet sind, dass jedem Rasterelement eines der Rasterelement-Typen (I bis III) einer der Rasteranordnungen (12) mindestens ein individueller freier Abstand ($\Delta_I$, $\Delta_{II}$, $\Delta_{III}$) zwischen dem Rasterelement (24) dieses Typs (I bis III) und dem zugeordneten Rasterelement (26) der anderen Rasteranordnung (15) zugeordnet ist.

2. Beleuchtungssystem nach Anspruch 1, **dadurch gekennzeichnet, dass** mindestens eine der Rasteranordnungen (12, 15) mindestens eine Abstandsstufe (36; 40) zwischen einem ersten Rasterbereich (29; 37, 39; 38) mit mindestens einem Rasterelement (24) des ersten Rasterelement-Typs (I) und einem zweiten Rasterbereich (27, 28, 30, 31; 38; 37, 39) mit mindestens einem Rasterelement (24) des zweiten Rasterelement-Typs (II, III) aufweist.

3. Beleuchtungssystem nach Anspruch 2, **dadurch gekennzeichnet, dass** mindestens einer der Rasterbereiche (28, 30; 37 bis 39) eine Mehrzahl von Rasterelementen (24) des gleichen Rasterelement-Typs (I bis III) aufweist.

4. Beleuchtungssystem nach Anspruch 2 oder 3, **dadurch gekennzeichnet, dass** das mindestens eine die Abstandsstufe (36; 40) aufweisende Rasterelement (12, 15) im Zentrum des Rasterelements (12, 15) eine größte Stärke ($S_I$) aufweist, die zum Rand hin stufenweise geringer wird.

5. Beleuchtungssystem nach Anspruch 2 oder 3, **dadurch gekennzeichnet, dass** das mindestens eine die Abstandsstufe (36; 40) aufweisende Rasterelement (12, 15) im Zentrum des Rasterelements (12, 15) eine kleinste Stärke $S_{III}$ aufweist, die zum Rand hin stufenweise größer wird.

6. Beleuchtungssystem nach einem der Ansprüche 1 bis 5, **dadurch gekennzeichnet, dass** zumindest einige der Rasterelement-Typen (I bis III) als asphärische Rasterelemente (24) ausgeführt sind.

7. Beleuchtungssystem nach Anspruch 6, **dadurch gekennzeichnet, dass** die Rasterelement-Typen (I bis III) eine unterschiedliche konische Konstante (C) aufweisen.

8. Beleuchtungssystem (5) für die Mikro-Lithographie zur Beleuchtung eines Beleuchtungsfeldes (3) mit Beleuchtungslicht (8) einer primären Lichtquelle (6),

   - mit einer ersten Rasteranordnung (12) mit bündelformenden ersten Rasterelementen (24), die in einer ersten Ebene (11) des Beleuchtungssystems (5) oder benachbart zu dieser angeordnet sind, zur Erzeugung einer Rasteranordnung sekundärer Lichtquellen,
   - mit einer Übertragungsoptik (15, 17) zur überlagernden Übertragung des Beleuchtungslichts (8) der sekundären Lichtquellen in das Beleuchtungsfeld (3),
   - wobei die Übertragungsoptik (15, 17) eine zweite Rasteranordnung (15) mit bündelformenden zweiten Rasterelementen (26) aufweist,
   - mit einer Verlagerungseinrichtung (41) zur Verlagerung eines Abschnitts (26; 45, 47) der ersten Rasteranordnung (12) relativ zur zweiten Rasteranordnung (15), **dadurch gekennzeichnet, dass** es sich bei dem mittels der Verlagerungseinrichtung verlagerbaren Abschnitt um genau eines der Rasterelemente, um eine Gruppe von mehreren Rasterelementen oder um mehrere Gruppen von Rasterelementen, nicht aber um die gesamte Rasteranordnung handelt.

9. Beleuchtungssystem nach Anspruch 8, wobei die Verlagerungseinrichtung (41) und die beiden Rasteranordnungen (12, 15) so zueinander angeordnet sind, dass der Abschnitt (26; 45, 47) der ersten Rasteranordnung (12) quer zu einer Strahlrichtung des Beleuchtungslichts relativ zur zweiten Rasteranordnung (15) verlagerbar ist.

10. Beleuchtungssystem nach Anspruch 8 oder 9, wobei die Verlagerungseinrichtung (41) und die beiden Rasteranordnungen (12, 15) so zueinander angeordnet und ausgeführt sind, dass der Abschnitt (26; 45: 47) der ersten Rasteranordnung (12) relativ zur zweiten Rasteranordnung (15) verschwenkbar ausgeführt ist.

11. Beleuchtungssystem nach einem der Ansprüche 8 bis 10, **dadurch gekennzeichnet, dass** die Verlagerungseinrichtung (41) derart ausgeführt ist, dass eine periodische Verlagerung mindestens eines Abschnitts der ersten Rasteranordnung (12) relativ zur zweiten Rasteranordnung (15) mit einer Periode stattfindet, die klein ist gegenüber einer Beleuchtungsdauer des Beleuchtungsfeldes (3) bei der lithographischen Projektionsbelichtung.

12. Beleuchtungssystem nach einem der Ansprüche 8 bis 11, **gekennzeichnet durch**

   - eine Messeinrichtung (44) zur Erfassung einer Beleuchtungsintensitätsverteilung des Beleuchtungslichts (8),
   - mit einer Regeleinrichtung, die mit der Messeinrichtung (44) und der Verlagerungseinrichtung (41) in Signalverbindung steht.

13. Projektionsbelichtungsanlage (1) mit einem Beleuchtungssystem (5) nach einem der Ansprüche 1 bis 12.

14. Verfahren zur mikrolithographischen Herstellung mikrostrukturierter Bauelemente mit folgenden Schritten:

- Bereitstellen eines Substrats, auf das zumindest teilweise eine Schicht aus einem lichtempfindlichen Material aufgebracht ist,
- Bereitstellen eines Retikels, das abzubildende Strukturen aufweist,
- Bereitstellen einer Projektionsbelichtungsanlage (1) nach Anspruch 13, wobei die abzubildenden Strukturen im Beleuchtungsfeld angeordnet sind,
- Projizieren wenigstens eines Teils des Retikels auf einen Bereich der Schicht mit Hilfe der Projektionsbelichtungsanlage (1).

**Claims**

1. Microlithographic illumination system (5) for illuminating an illumination field (3) with illumination light (8) from a primary light source (6),

- comprising a first raster arrangement (12) with beam-forming first raster elements (24), which are arranged in a first plane (11) of the illumination system (5) or adjacent thereto, for generating a raster arrangement of secondary light sources,
- comprising a transfer optical unit (15, 17) for superposed transfer of the illumination light (8) from the secondary light sources into the illumination field (3),
- wherein the transfer optical unit (15, 17) comprises a second raster arrangement (15) with beam-forming second raster elements (26),
- wherein respectively one of the raster elements (24) of the first raster arrangement (12) is assigned to one of the raster elements (26) of the second raster arrangement (15) for guiding a partial beam (25) of a whole beam of the illumination light (8),
- wherein the illumination light (8) is subdivided into a number of partial beams (25) corresponding to the number of illuminated first raster elements (24) on account of the beam-forming effect of the first raster elements (24) of the first raster arrangement (12),
- wherein the second raster elements (26) of the second raster arrangement (15) are assigned to the first raster elements (24) of the first raster arrangement (12) for guiding the respective partial beam (25),

**characterized in that**

- at least one of the two raster arrangements (12) has at least two types (I, II, III) of the raster elements (24), said types differing in terms of the beam-influencing effect thereof, wherein the beam-influencing effect is a converging effect,
- wherein the raster elements (24, 26) of the two raster arrangements (12, 15) are arranged relative to one another in such a way that at least one individual free gap ($\Delta_I$, $\Delta_{II}$, $\Delta_{III}$) is assigned to each raster element of one of the raster element types (I to III) of one of the raster arrangements (12), said gap being between the raster element (24) of this type (I to III) and the assigned raster element (26) of the other raster arrangement (15).

2. Illumination system according to Claim 1, **characterized in that** at least one of the raster arrangements (12, 15) comprises at least one spacing step (36; 40) between a first raster region (29; 37, 39; 38) with at least one raster element (24) of the first raster element type (I) and a second raster region (27, 28, 30, 31; 38; 37, 39) with at least one raster element (24) of the second raster element type (II, III).

3. Illumination system according to Claim 2, **characterized in that** at least one of the raster regions (28, 30; 37 to 39) has a plurality of raster elements (24) of the same raster element type (I to III).

4. Illumination system according to Claim 2 or 3, **characterized in that** the at least one raster element (12, 15) having the spacing step (36; 40) has a greatest thickness ($S_I$) in the centre of the raster element (12, 15), said thickness decreasing towards the edge in a step-shaped manner.

5. Illumination system according to Claim 2 or 3, **characterized in that** the at least one raster element (12, 15) having the spacing step (36; 40) has a smallest thickness ($S_{III}$) in the centre of the raster element (12, 15), said thickness increasing towards the edge in a step-shaped manner.

**6.** Illumination system according to one of Claims 1 to 5, **characterized in that** at least some of the raster element types (I to III) are embodied as aspherical raster elements (24).

**7.** Illumination system according to Claim 6, **characterized in that** the raster element types (I to III) have different conic constants (C).

**8.** Microlithographic illumination system (5) for illuminating an illumination field (3) with illumination light (8) from a primary light source (6),

- comprising a first raster arrangement (12) with beam-forming first raster elements (24), which are arranged in a first plane (11) of the illumination system (5) or adjacent thereto, for generating a raster arrangement of secondary light sources,
- comprising a transfer optical unit (15, 17) for superposed transfer of the illumination light (8) from the secondary light sources into the illumination field (3),
- wherein the transfer optical unit (15, 17) comprises a second raster arrangement (15) with beam-forming second raster elements (26),
- comprising a displacing device (41) for displacing a portion (26; 45, 47) of the first raster arrangement (12) relative to the second raster arrangement (15), **characterized in that** the portion displaceable by means of the displacing device is precisely one of the raster elements, a group of a plurality of raster elements or a plurality of groups of raster elements, but not the entire raster arrangement.

**9.** Illumination system according to Claim 8, wherein the displacing device (41) and the two raster arrangements (12, 15) are arranged relative to one another in such a way that the portion (26; 45, 47) of the first raster arrangement (12) is displaceable relative to the second raster arrangement (15) across a beam direction of the illumination light.

**10.** Illumination system according to Claim 8 or 9, wherein the displacing device (41) and the two raster arrangements (12, 15) are arranged relative to one another and embodied in such a way that the portion (26; 45: 47) of the first raster arrangement (12) is embodied in a manner swivellable relative to the second raster arrangement (15).

**11.** Illumination system according to one of Claims 8 to 10, **characterized in that** the displacing device (41) is embodied in such a way that a periodic displacement of at least one portion of the first raster arrangement (12) relative to the second raster arrangement (15) occurs with a period which is short in relation to an illumination duration of the illumination field (3) during lithographic projection exposure.

**12.** Illumination system according to one of Claims 8 to 11, **characterized by**

- a measuring device (44) for capturing an illumination intensity distribution of the illumination light (8),
- comprising a regulating device which has a signal connection to the measuring device (44) and the displacing device (41).

**13.** Projection exposure apparatus (1) comprising an illumination system (5) according to one of Claims 1 to 12.

**14.** Method for microlithographic production of microstructured components, comprising the following steps:

- providing a substrate, onto at least part of which a layer made of a light-sensitive material has been applied,
- providing a reticle having structures to be imaged,
- providing a projection exposure apparatus (1) according to Claim 13, wherein the structures to be imaged are arranged in the illumination field,
- projecting at least part of the reticle onto a region of the layer with the aid of the projection exposure apparatus (1).

**Revendications**

**1.** Système d'éclairage (5) pour la microlithographie servant à éclairer un champ d'éclairage (3) avec une lumière d'éclairage (8) d'une source lumineuse primaire (6),

- comportant un premier agencement de trames (12) ayant des premiers éléments de trames (24) formant des faisceaux, qui sont disposés dans un premier plan (11) du système d'éclairage (5) ou au voisinage de celui-ci, pour générer un agencement de trames de sources lumineuses secondaires,

- comportant une optique de transmission (15, 17) pour la transmission superposée de la lumière d'éclairage (8) des sources lumineuses secondaires dans le champ d'éclairage (3),
- dans lequel l'optique de transmission (15, 17) comporte un deuxième agencement de trames (15) doté de deuxièmes éléments de trames (26) formant des faisceaux,
- dans lequel l'un respectif des éléments de trames (24) du premier agencement de trames (12) est associé à l'un des éléments de trames (26) du deuxième agencement de trames (15) afin de guider un faisceau partiel (25) d'un faisceau complet de la lumière d'éclairage (8),
- dans lequel, du fait de l'effet de formation de faisceau des premiers éléments de trames (24) du premier agencement de trames (12), la lumière d'éclairage (8) est divisée en un nombre de faisceaux partiels (25) correspondant au nombre des premiers éléments de trames (24) éclairés,
- dans lequel les deuxièmes éléments de trames (26) du deuxième agencement de trames (15) sont associés aux premiers éléments de trames (24) du premier agencement de trames (12) pour guider le faisceau partiel (25) respectif,

**caractérisé en ce que** :

- au moins l'un des deux agencements de trames (12) comporte au moins deux types (I, II, III) des éléments de trames (24), qui diffèrent par leur effet sur le faisceau, dans lequel l'effet sur le faisceau est un effet de rassemblement,
- dans lequel les éléments de trames (24, 26) des deux agencements de trames (12, 15) sont disposés les uns par rapport aux autres de telle sorte que, à chaque élément de trame de l'un des types d'éléments de trames (I à III) de l'un des agencements de trames (12), est associée au moins une distance libre individuelle ($\Delta_I$, $\Delta_{II}$, $\Delta_{II}$) entre l'élément de trame (24) de ce type (I à III) et l'élément associé (26) de l'autre agencement de trames (15).

2. Système d'éclairage selon la revendication 1, **caractérisé en ce qu'**au moins l'un des agencements de trames (12, 15) présente au moins un pas de distance (36 ; 40) entre une première zone de trames (29 ; 37, 39 ; 38) comportant au moins un élément de trame (24) du premier type d'élément de trame (I) et une deuxième zone de trames (27, 28, 30, 31 ; 38 ; 37, 39) comportant au moins un élément de trame (24) du deuxième type d'élément de trame (II, III).

3. Système d'éclairage selon la revendication 2, **caractérisé en ce qu'**au moins l'une des zones de trames (28, 30 ; 37 à 39) comporte une pluralité d'éléments de trames (24) du même type d'élément de trame (I à III).

4. Système d'éclairage selon la revendication 2 ou 3, **caractérisé en ce qu'**au moins un élément de trame (12, 15) présentant le pas de distance (36 ; 40) présente une intensité ($S_I$) plus élevée au centre de l'élément de trame (12, 15), qui diminue pas à pas vers le bord.

5. Système d'éclairage selon la revendication 2 ou 3, **caractérisé en ce qu'**au moins un élément de trame (12, 15) présentant le pas de distance (36 ; 40) présente une intensité la plus faible $S_{III}$ au centre de l'élément de trame (12, 15), qui augmente pas à pas vers le bord.

6. Système d'éclairage selon l'une quelconque des revendications 1 à 5, **caractérisé en ce qu'**au moins certains des types d'éléments de trames (I à III) sont réalisés sous la forme d'éléments de trames (24) asphériques.

7. Système d'éclairage selon la revendication 6, **caractérisé en ce que** les types d'éléments de trames (I à III) présentent des constantes de conicité différentes (C).

8. Système d'éclairage (5) pour la microlithographie servant à éclairer un champ d'éclairage (3) avec une lumière d'éclairage (8) d'une source lumineuse primaire (6),

- comportant un premier agencement de trames (12) ayant des premiers éléments de trames (24) formant des faisceaux, qui sont disposés dans un premier plan (11) du système d'éclairage (5) ou au voisinage de celui-ci, pour générer un agencement de trames de sources lumineuses secondaires,
- comportant une optique de transmission (15, 17) pour la transmission superposée de la lumière d'éclairage (8) des sources lumineuses secondaires dans le champ d'éclairage (3),
- dans lequel l'optique de transmission (15, 17) comporte un deuxième agencement de trames (15) doté de deuxièmes éléments de trames (26) formant des faisceaux,
- comportant un dispositif de déplacement (41) destiné à déplacer une partie (26 ; 45, 47) du premier agencement de trames (12) par rapport au deuxième agencement de trames (15), **caractérisé en ce que** la partie pouvant être déplacée au moyen du dispositif de déplacement est exactement l'un des éléments de trames, un groupe de plusieurs éléments de trames ou plusieurs groupes d'éléments de trames, mais pas la totalité de l'agencement de trames.

9. Système d'éclairage selon la revendication 8, dans lequel le dispositif de déplacement (41) et les deux agencements de trames (12, 15) sont disposés les uns par rapport aux autres de manière à ce que la partie (26 ; 45, 47) du premier agencement de trames (12) puisse être déplacée transversalement à une direction de rayonnement de la lumière d'éclairage par rapport au deuxième agencement de trames (15).

10. Système d'éclairage selon la revendication 8 ou 9, dans lequel le dispositif de déplacement (41) et les deux agencements de trames (12, 15) sont disposés les uns par rapport aux autres et sont réalisés de manière à ce que la partie (26 ; 45, 47) du premier agencement de trames (12) soit réalisée de manière à pouvoir pivoter par rapport au deuxième agencement de trames (15).

11. Système d'éclairage selon l'une quelconque des revendications 8 à 10, **caractérisé en ce que** le dispositif de déplacement (41) est réalisé de manière à ce qu'un déplacement périodique d'au moins une partie du premier agencement de trames (12) par rapport au deuxième agencement de trames (15) se produise avec une faible période par rapport à une durée d'éclairage du champ d'éclairage (3) lors de l'éclairage par projection lithographique.

12. Système d'éclairage selon l'une quelconque des revendications 8 à 11, **caractérisé par**

    - un dispositif de mesure (44) destiné à détecter une distribution d'intensité d'éclairage de la lumière d'éclairage (8),
    - comportant un dispositif de régulation qui est en liaison de signal avec le dispositif de mesure (44) et le dispositif de déplacement (41).

13. Installation d'éclairage à projection (1) comportant un système d'éclairage (5) selon l'une quelconque des revendications 1 à 12.

14. Procédé pour la fabrication par microlithographie de composants microstructurés, comportant les étapes consistant à :

    - fournir un substrat sur lequel une couche de matériau sensible à la lumière est appliqué au moins partiellement,
    - fournir un réticule qui présente des structures dont des images doivent être formées,
    - fournir une installation d'éclairage à projection (1) selon la revendication 13, dans lequel les structures dont les images doivent être formées sont disposées dans le champ d'éclairage,
    - projeter au moins une partie du réticule sur une zone de la couche au moyen de l'installation d'éclairage à projection (1).

EP 2 382 510 B1

Fig. 1

20

Fig. 2

Ⅲ Ⅱ Ⅰ Ⅱ Ⅲ

25

12

25

27

30

25

31

28  25  29

y

x

Fig. 3

34  32  33

I

Ⅰ

Ⅲ

E-
Offset

x

3

Fig. 4

Fig. 5

Fig. 6

Fig. 7

Fig. 8

Fig. 9

Fig. 10

Fig. 11

EP 2 382 510 B1

Fig. 12

Fig. 13

Fig. 14

Fig. 15

Fig. 16

Fig. 17

Fig. 18

Fig. 19

Fig. 20

Fig. 21

**IN DER BESCHREIBUNG AUFGEFÜHRTE DOKUMENTE**

**In der Beschreibung aufgeführte Patentdokumente**

- WO 2007093433 A1
- EP 1521111 A1
- US 5237367 A
- EP 0844530 A2
- US 5251067 A
- US 5963305 A
- DE 10344010 A1